(19) Europäisches Patentamt
European Patent Office
Office européen des brevets

(11) EP 2 133 399 A1

(12) **EUROPEAN PATENT APPLICATION**
published in accordance with Art. 153(4) EPC

(43) Date of publication:
**16.12.2009 Bulletin 2009/51**

(21) Application number: **08739712.1**

(22) Date of filing: **02.04.2008**

(51) Int Cl.:
***C09J 183/12*** *(2006.01)* ***C09J 7/02*** *(2006.01)*
***C09J 201/10*** *(2006.01)* ***G02B 1/10*** *(2006.01)*

(86) International application number:
**PCT/JP2008/056602**

(87) International publication number:
**WO 2008/123552 (16.10.2008 Gazette 2008/42)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **03.04.2007 JP 2007097307**
**25.10.2007 JP 2007277803**

(71) Applicant: **Asahi Glass Company, Limited**
**Chiyoda-ku**
**Tokyo 100-8405 (JP)**

(72) Inventors:
- **YASUDA, Teruhiko**
**Kamisu-city**
**Ibaraki 314-0195 (JP)**
- **SHIMOMA, Hitoshi**
**Kamisu-city**
**Ibaraki 314-0195 (JP)**
- **SATO, Hisashi**
**Kamisu-city**
**Ibaraki 314-0195 (JP)**

(74) Representative: **Hartz, Nikolai**
**Wächtershäuser & Hartz**
**Patentanwälte**
**Weinstrasse 8**
**80333 München (DE)**

(54) **ADHESIVE MATERIAL, ADHESIVE SHEET, AND USE OF THE ADHESIVE SHEET**

(57) To provide an adherence substance which has a low viscosity and good coatability, can be made solvent free, has good adhesion to an adherend and at the same time has excellent removability, can suppress peel electrostatic charge and is excellent in high speed peeling performance.

An adherence substance which is obtainable by curing a curable composition comprising a silyl group-containing polymer (S) represented by the following formula (1):

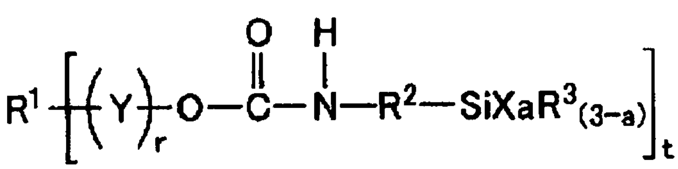
(1)

in the formula (1), $R^1$ represents a t-valent residue obtained by removing all hydroxy groups from a compound having t pieces of hydroxy groups in the molecule; $R^2$ represents a bivalent organic group; $R^3$ represents a monovalent organic group having from 1 to 20 carbon atoms; X is a hydroxy group or a hydrolyzable group; Y represents a bivalent group represented by the following formula (A) or a bivalent group represented by the following formula (B); a represents an integer of from 1 to 3; r represents an integer of from 1 to 1,000; t represents an integer of from 1 to 8;

EP 2 133 399 A1

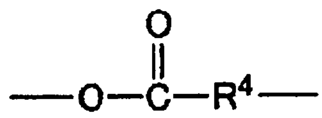 (A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

## Description

TECHNICAL FIELD

The present invention relates to an adherence substance, a pressure sensitive adhesive sheet and its use

BACKGROUND ART

An adhesive is required to adhere to an adherend so that it would hardly be peeled. On the other hand, a pressure sensitive adhesive is formed into a shape of a tape or the like and is required to exhibit good adhesion immediately upon lamination. At the same time, the pressure sensitive adhesive is required to have removability so that it can be peeled without leaving an adhesive deposit. While permanent adhesion is required for an adhesive, a pressure sensitive adhesive is required to have both temporary adhesion and removability. Thus, although an adhesive and a pressure sensitive adhesive are alike, they are fundamentally different in the required properties.

As conventional pressure sensitive adhesives, an acrylic pressure sensitive adhesive, a rubber pressure sensitive adhesive, a silicone pressure sensitive adhesive, an urethane pressure sensitive adhesive and an oxalkylene pressure sensitive adhesive are known. Particularly, it has been a recent tendency that an acrylic pressure sensitive adhesive is used in a wide range of applications from a strongly adhesive pressure sensitive adhesive having a strong adhesive strength to a weakly adhesive pressure sensitive adhesive having a weak adhesive strength. However, an acrylic pressure sensitive adhesive has a problem of an odor or dermal irritation in a case where an acrylic monomer remains in the pressure sensitive adhesive. Further, an acrylic pressure sensitive adhesive is likely to undergo a change with time after being applied to an adherend, whereby the adhesive strength tends to increase, or migration tends to be high. Accordingly, there has been a problem such that an adhesive deposit is likely to remain on the adherend, and the removability tends to be inadequate.

In the case of a rubber pressure sensitive adhesive, it is necessary to add a low molecular weight plasticizer to adjust the adhesive performance or for handling efficiency. Therefore, there is a problem such that upon expiration of a long period of time, the low molecular weight plasticizer migrates to the surface, thus bringing about a remarkable deterioration of the performance.

A silicon pressure sensitive adhesive is excellent in heat resistance. However, it is expensive and is used only for special applications.

An urethane pressure sensitive adhesive has a characteristic such that it is excellent in stability with little change with time (Patent Document 1). However, its production process tends to be long, and as compared with an acrylic pressure sensitive adhesive, it tends to be expensive. Further, as the production process is long, there has been a problem that fluctuation in the quality is likely to result, or the process management tends to be cumbersome.

An oxyalkylene pressure sensitive adhesive has a characteristic such that it can be applied without using an organic solvent (Patent Documents 2 and 3). However, bleeding of an adhesion-imparting resin may sometimes occur, and there has been a problem from the viewpoint of the stability of the adhesive strength for a long period of time.

In recent years, a protective sheet or a protective tape has been frequently used during the production of electric components or electronic materials. The purpose is to protect such components or materials from scratching or dusts in the process for transportation, storage, etc. Particularly, in the production of electronic components or optical materials, it is necessary to completely prevent fine dusts from attaching to a product during its production. Because, dusts will cause contamination and thus cause product failure. As such a protective sheet or a protective tape, a pressure sensitive adhesive sheet or a pressure sensitive adhesive tape provided with a pressure sensitive adhesive layer having a low adhesive strength, is employed. For such a pressure sensitive adhesive sheet or a pressure sensitive adhesive tape, a separator may be employed to protect the pressure sensitive adhesive layer. Contamination caused by such a separator has become a problem in recent years (Patent Document 4). That is, silicone contained in the separator causes contamination of an electronic component. Accordingly, a pressure sensitive adhesive sheet having a separator not-using a silicone releasing agent, has been desired.

Patent Document 1: JP-A-2003-12751
Patent Document 2: WO2005/73333
Patent Document 3: WO2005/73334
Patent Document 4: JP-A-06-297645

## DISCLOSURE OF THE INVENTION

## PROBLEMS TO BE SOLVED BY THE INVENTION

A conventional pressure sensitive adhesive such as an acrylic pressure sensitive adhesive has had a problem such that the adhesive strength tends to increase as the time passes. Particularly in a case where it is desired to produce a pressure sensitive adhesive having a weak adhesive strength, there has been a problem such that even if the composition of the pressure sensitive adhesive is adjusted so that the initial adhesive strength be low, the adhesive strength is likely to increase as the adhesion time becomes long. If the adhesive strength increases, the adherend is likely to be deformed and may possibly be broken. On the other hand, if the composition of the pressure sensitive adhesive is adjusted to make the adhesive strength to be low upon expiration of a certain time, there has been a problem that no adequate adhesive strength is obtainable even at the initial stage. If no adequate adhesive strength is obtainable, it is likely to be peeled from the adherend unintentionally, and it can not perform a prescribed role as e.g. a protective sheet. Further, the thickness of the pressure sensitive adhesive layer may be made thin in order to control the increase of the adhesive strength. In such a case, the essential function of the pressure sensitive adhesive to adhere to the adherend under light pressure, is likely to be impaired.

In the Patent Document 1, at the time of producing a resin as a raw material for the disclosed urethane pressure sensitive adhesive, a slight difference in the reactivity of the raw material is utilized to obtain a polymer having a prescribed structure. However, in order to control the structure by the difference in the reactivity, it is necessary to control the reaction conditions precisely. Consequently, in the production of this resin, control of the molecular weight is difficult, and it was difficult to obtain a pressure sensitive adhesive having a desired performance. Particularly, it was difficult to control the formation of a high molecular weight product and the progress in gelation along with the formation. The molecular weight relates to molecular cohesion and influential over the adhesion and removability. Further, if the gelation proceeds too much, the obtainable composition tends to have a high viscosity. If the composition has a high viscosity, at the time of mold processing of the pressure sensitive adhesive, it tends to be difficult to obtain an adherence substance layer having a uniform prescribed thickness, or the surface of the obtained adherence substance is likely to be not smooth, and thus there has been a problem from the viewpoint of the production. Even if the apparent viscosity is lowered by means of a solvent, there will be a problem such that a thick adherence substance is hardly obtainable, bubbling is likely to result, or a long time is required for drying.

Further, a protective sheet or a protective tape is peeled and removed upon completion of its role to temporarily fix or protect a component. However, at the time of peeling the protective sheet from the component to which it was bonded, static electricity (so-called peel electrostatic charge) will be caused between the protective sheet and the component. There is a problem that such static electricity generates an adverse effect to a circuit of an electronic component, or dust or foreign particles are likely to deposit on the surface of the component due to such static electricity. Further, a surface protective film of a liquid crystal display (LCD) is also peeled and removed at the time of using the display. When such a protective film is peeled from the liquid crystal display, a peel electrostatic charge may sometimes be generated. There may be a case of a trouble such that by the peel electrostatic charge, the liquid crystal alignment is disordered, and the image is disturbed.

Accordingly, for the pressure sensitive adhesive sheet to be peeled after being bonded, it is required to suppress the generation of static electricity caused by the peel electrostatic charge or to quickly remove the generated static electricity. Because, the surface electrification of the adherend will cause deposition of dust or foreign particles on the adherend, or will cause deterioration of the function of the adherend.

Further, the tensile strength (peel strength) required to peel a pressure sensitive adhesive sheet usually tends to be large as the tension rate (the peeling speed) becomes high. For example, a surface protective sheet for e.g. an electronic device such as a display, a polarizing plate, an electronic substrate or an IC chip is preferably peeled smoothly at a high speed. It is required that the peel strength in the case of peeling at a high speed will not be large as compared with the peel strength in the case of peeling at a low speed. That is, a protective sheet is required to have a low speed dependency of the peel strength and to be excellent in the high speed peeling property.

The present invention has been made in view of the above problems. That is, it is an object of the present invention to provide an adherence substance which has a low viscosity and good coatabilty, can be made solvent-free, has good adhesion to an adherend, is excellent in removability with a low adhesive strength and has a good wettability.

Further, it is an object of the present invention to provide an adherence substance which has a peel electrostatic charge suppressed, is excellent in a high speed peeling property and is free from contamination with e.g. silicone.

## MEANS TO SOLVE THE PROBLEMS

In order to solve the above problems, the present invention provides the following.

<1> An adherence substance which is obtainable by curing a curable composition comprising a silyl group-containing polymer (S) represented by the following formula (1) and which has a peel adhesive strength of at most 1 N/25mm:

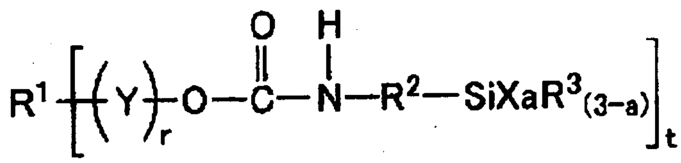 (1)

in the formula (1), $R^1$ represents a t-valent residue obtained by removing all hydroxy groups from a compound having t pieces of hydroxy groups in the molecule; $R^2$ represents a bivalent organic group; $R^3$ represents a monovalent organic group having from 1 to 20 carbon atoms; X is a hydroxy group or a hydrolyzable group; Y represents a bivalent group represented by the following formula (A) or a bivalent group represented by the following formula (B); a represents an integer of from 1 to 3; r represents an integer of from 1 to 1,000; t represents an integer of from 1 to 8; when t is from 2 to 8, t pieces of monovalent groups bonded to $R^1$may be the same or different from one another; when a is 2 or 3, 2 or 3 pieces of X bonded to one silicon atom may be the same or different from one another; when a is 1, 2 pieces of $R^3$ bonded to one silicon atom may be the same or different from each other; and when r is 2 or more, the plurality of Y bonded to one another, may be the same or different from one another;

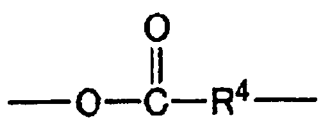 (A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

<2> The adherence substance according to the above <1>, wherein the curable composition comprises, as the silyl group-containing polymer (S), a polyester ether type silyl group-containing polymer (S1) which is represented by the above formula (1) wherein r is an integer of from 2 to 1,000, and Y is a bivalent group represented by the formula (A) and a bivalent group represented by the formula (B).

<3> The adherence substance according to the above <2>, wherein the polyester ether type silyl group-containing polymer (S1) is a polymer obtainable via a first step of reacting an initiator (z) made of a compound having from 1 to 8 hydroxy groups in the molecule, a cyclic ester compound (a) having from 3 to 9 carbon atoms and an alkylene oxide (b) having from 2 to 4 carbon atoms in the presence of a polymerization catalyst to obtain a polyester ether poly(mono)ol (p1), and a second step of reacting the polyester ether poly(mono)ol (p1) with a silyl isocyanate compound (i) in the presence of an urethane-forming catalyst to obtain the polyester ether type silyl group-containing polymer (S1).

<4> The adherence substance according to the above <3>, wherein in the polyester ether type silyl group-containing polymer (S1), the mass ratio of the bivalent group represented by the formula (A) derived from the cyclic ester compound (a) to the bivalent group represented by the formula (B) derived from the alkylene oxide (b) i.e. (A):B), is from 95:5 to 5:95.

<5> The adherence substance according to the above <3> or <4>, wherein the initiator (z) is a polyoxyalkylene poly (mono)ol (z2) which has from 1 to 8 hydroxy groups in the molecule and which also has an oxyalkylene group, and the polyester ether type silyl group-containing polymer (S1) is a polymer represented by the following formula (2):

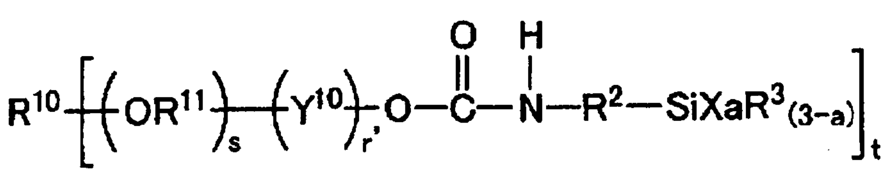 (2)

in the formula (2), $R^{10}$ represents a t-valent hydrocarbon group having from 1 to 20 carbon atoms; $R^{11}$ represents an alkylene group having from 2 to 4 carbon atoms derived from the polyoxyalkylene poly(mono)ol (z2); $R^2$ represents a bivalent organic group; $R^3$ represents a monovalent organic group having from 1 to 20 carbon atoms; X is a hydroxy group or a hydrolyzable group; $Y^{10}$ represents a bivalent group represented by the following formula (A) derived from the cyclic ester compound (a) or a bivalent group represented by the following formula (B) derived from the alkylene oxide (b); a represents an integer of from 1 to 3; r' represents an integer of at least 1; s represents an integer of from 1 to 250; the sum of r' and s is an integer of from 2 to 1,000; t represents an integer of from 1 to 8; when t is from 2 to 8, t pieces of monovalent groups bonded to $R^{10}$ may be the same or different from one another; when a is 2 or 3, 2 or 3 pieces of X bonded to one silicon atom may be the same or different from one another; when a is 1, 2 pieces of $R^3$ bonded to one silicon atom may be the same or different from each other; when r' is 2 or more, the plurality of $Y^{10}$ bonded to one another, may be the same or different from one another; and when s is 2 or more, the plurality of $-OR^{11}-$ bonded to one another, may be the same or different from one another

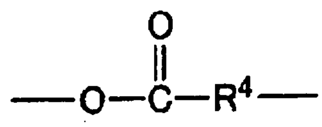

(A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

<6> The adherence substance according to any one of the above <3> to <5>, wherein the polyester ether poly (mono)ol (p1) has an average hydroxy value (OHV) of from 10 to 230 mgKOH/g.

<7> The adherence substance according to any one of the above <1> to <6>, wherein the curable composition further contains another silyl group-containing polymer (S4) represented by the following formula (3):

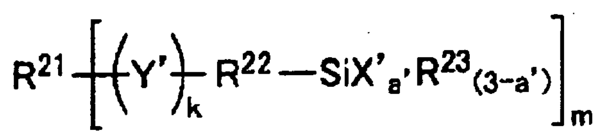

(3)

in the formula (3), $R^{21}$ represents a m-valent residue obtained by removing all hydroxy groups from a compound having m pieces of hydroxy groups in the molecule; $R^{22}$ represents a bivalent organic group; $R^{23}$ represents a monovalent organic group having from 1 to 20 carbon atoms; X' is a hydroxy group or a hydrolyzable group; Y' represents an oxyalkylene group having from 2 to 4 carbon atoms; a' represents an integer of from 1 to 3; k represents an integer of from 1 to 10,000; m represents an integer of from 1 to 8; when m is from 2 to 8, m pieces of monovalent groups bonded to $R^{21}$ may be the same or different from one another; when a' is 2 or 3, 2 or 3 pieces of X' bonded to one silicon atom may be the same or different from one another; when a' is 1, 2 pieces of $R^{23}$ bonded to one silicon atom may be the same or different from each other; and when k is 2 or more, the plurality of Y' bonded to one another, may be the same or different from one another.

<8> An adherence substance which is obtainable by curing a curable composition comprising a silyl group-containing polymer (S) represented by the following formula (1):

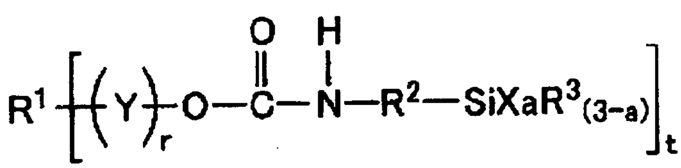

(1)

in the formula (1), $R^1$ represents a t-valent residue obtained by removing all hydroxy groups from a compound having t pieces of hydroxy groups in the molecule; $R^2$ represents a bivalent organic group; $R^3$ represents a monovalent

organic group having from 1 to 20 carbon atoms; X is a hydroxy group or a hydrolyzable group; Y represents a combination of a bivalent group represented by the following formula (A) and a bivalent group represented by the following formula (B), or a combination of only a bivalent group represented by the following formula (A); a represents an integer of from 1 to 3; r represents an integer of from 2 to 1,000; t represents an integer of from 1 to 8; when t is from 2 to 8, t pieces of monovalent groups bonded to $R^1$ may be the same or different from one another; when a is 2 or 3, 2 or 3 pieces of X bonded to one silicon atom may be the same or different from one another; when a is 1, 2 pieces of $R^3$ bonded to one silicon atom may be the same or different from each other; and the plurality of Y bonded to one another, may be the same or different from one another;

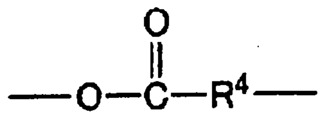 (A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

<9> A pressure sensitive adhesive sheet comprising a substrate layer and at least one layer of an adherence substance, wherein the adherence substance is one as defined in any one of the above <1> to <8>.

<10> An optical element protective pressure sensitive adhesive sheet comprising a substrate layer and at least one layer of an adherence substance, wherein the adherence substance is one as defined in any one of the above <1> to <8>.

<11> An optical element having the optical element protective pressure sensitive adhesive sheet as defined in the above <10> bonded thereon.

<12> The optical element according to the above <11>, wherein the optical element is a light diffusing plate or a prism sheet.

<13> A back grinding tape comprising a substrate layer and at least one layer of an adherence substance, wherein the adherence substance is one as defined in any one of the above <1> to <8>.

## EFFECTS OF THE INVENTION

The curable composition of the present invention is one using a hydrolyzable silyl group for a chain-extending mechanism. According to the present invention, it is possible to obtain an adherence substance which has a low viscosity and good coatability, can be made solvent-free, has good adhesion to an adherend while the adhesive strength is low, and which is excellent in removability and has good wettability.

Further, according to the present invention, it is possible to obtain an adherence substance which has a peel electrostatic charge suppressed, is excellent in the high speed peeling property and prevents contamination with e.g. silicone.

## BEST MODE FOR CARRYING OUT THE INVENTION

In this specification, the molecular weight distribution is a value obtained by dividing the mass average molecular weight (Mw) by the number average molecular weight (Mn). In this specification, the number average molecular weight (Mn), the mass average molecular weight (Mw) and the molecular weight distribution (Mw/Mn) are the molecular weight as calculated as polystyrene obtained by measurement by gel permeation chromatography employing a calibration curve prepared by using a standard polystyrene test sample having a known molecular weight.

In this specification, the average hydroxy value (OHV) is a value measured in accordance with JIS K-1557-6.4.

Further, in this specification, an adherence property is a property to adhere to an adherend under gentle pressure and to be optionally removable. Further, a pressure sensitive adhesive is a material which has the adherence property and adheres to an adherend under gentle pressure. However, it has removability and is used for temporary adhesion. An adhesive is different from a pressure sensitive adhesive in that it has a permanent adhesive property. Further, an adherence substance is a formed product having an adherence property. Further, a pressure sensitive adhesive sheet (which may simply be referred to as an adhesive sheet) is a sheet having an adherence property. However, in this specification, the thickness is not questioned, i.e. a sheet and a film are not distinguished. Usually, it is a laminate having at least a substrate layer and an adherence substance layer as constituting elements. Further, a pressure sensitive adhesive tape (which may simply be referred to as an adhesive tape) is a pressure sensitive sheet

in the form of a tape.

Further, a polyol or monool may generally be referred to as a poly(mono)ol.

In this specification, pressure sensitive adhesives may sometimes be classified by the peel adhesive strength (peel strength from the adherend). A case where the peel adhesive strength exceeds 0 N/25 mm and at most 1 N/25 mm may be referred to as "weakly adhesive"; a case where the peel adhesive strength exceeds 1 N/25 mm and at most 8 N/25 mm as "low adhesive"; a case where the peel adhesive strength exceeds 8 N/25 mm and at most 15 N/25 mm as "moderately adhesive"; and a case where the peel adhesive strength exceeds 15 N/25 mm and at most 50 N/25 mm as "strongly adhesive". Unless otherwise specified, peel adhesive strength is in accordance with the following test method in accordance with the 180° peeling method as defined in JIS Z-0237(1999)-8.3.1. In an environment of 23°C, a pressure sensitive sheet test piece to be measured (width: 25 mm) was adhered to a stainless steel plate (SU 304(JIS)) having a thickness of 1.5 mm and treated by bright annealing, and press-bonded by a rubber roll having a weight of 2 kg. 30 Minutes later, the peel strength (180° peeling, pulling speed: 300 mm/min) was measured by means of a tensile tester as defined in JIS B-7721.

<SILYL GROUP-CONTAINING POLYMER (S)>

The adherence substance of the present invention is obtainable by curing a curable composition comprising a silyl group-containing polymer (S) represented by the above formula (1).

In this specification, among silyl group-containing polymers (S), one wherein r is 2 or more, and r pieces of Y are a bivalent group represented by the above formula (A) (hereinafter sometimes referred to as a bivalent group (A)) and a bivalent group represented by the above formula (B) (hereinafter sometimes referred to as a bivalent group (B)), is referred to as a polyester ether type silyl group-containing polymer (S1) (hereinafter sometimes referred to as a polyester ether type polymer (S1)).

Among silyl group-containing polymers (S), one wherein Y is only a bivalent group (B), is referred to as a polyether type silyl group-containing polymer (S2) (hereinafter sometimes referred to as a polyether type polymer (S2)), and one wherein Y is only a bivalent group (A), is referred to as a polyester type silyl group-containing polymer (S3) (hereinafter sometimes referred to as a polyester type polymer (S3))

The polymer (S) contained in the curable composition of the present invention may be one type alone or a combination of two or more types, among the polyester ether type polymer (S1), the polyether type polymer (S2) and the polyester type polymer (S3). It preferably contains at least the polyester ether type polymer (S1).

<POLYESTER ETHER TYPE SILYL GROUP-CONTAINING POLYMER (S1)>

In the above formula (1), $R^1$ is a t-valent residue obtained by removing all hydroxy groups from a monohydroxy compound or polyhydroxy compound having t pieces of hydroxy groups in one molecule.

$R^1$ is a residue derived from an initiator (z) used for the production of the polymer (S1). Such an initiator (z) is a monohydroxy compound or polyhydroxy compound having from 1 to 8 hydroxy groups. The initiator (z) will be described hereinafter.

$R^1$ is preferably a t-valent hydrocarbon group having from 1 to 20 carbon atoms, more preferably a t-valent hydrocarbon group having from 1 to 10 carbon atoms.

If t in the formula (1), i.e. the number of hydroxy groups in the initiator (z), exceeds 8, the viscosity of a polyester ether poly(mono)ol (p1) (hereinafter sometime referred to as a poly(mono)ol (p1)) as an intermediate for the polyester ether type polymer (S1) tends to be high in a case where the molecular weight per hydroxy group is equal. Further, the molecular weight distribution of the poly(mono)ol (p1) tends to be broad. Accordingly, the flexibility of a polyester ether type polymer (S1) obtainable by using such a poly(mono)ol (p1) tends to be impaired, and the adherence property tends to be low. In a case where two or more compounds are used as initiators (z) to be used for the production of the polyester ether type polymer (S1), the average number of hydroxy groups per molecule (i.e. the average value of t in the polyester ether type polymer (S1) is preferably from 1 to 8, more preferably from 1 to 5, further preferably from 1 to 3. When the average number of hydroxy groups is within the above range, the viscosity is low, whereby the production is easy, and a good curing speed and flexibility can be provided.

In the above formula (1), $R^2$ represents a bivalent organic group. $R^2$ is preferably a bivalent hydrocarbon group having from 1 to 17 carbon atoms. In such a case, the raw material is available at a low cost, whereby the production cost can be reduced.

$R^2$ is more preferably a methylene group ($-CH_2-$) or a trimethylene group ($-CH_2CH_2CH_2-$). In such a case, there is a merit such that the curing speed and the storage stability of the polyester ether type polymer (S1) will be well balanced.

Further, in the above formula (1), $-R^2-SiX_aR^3_{(3-a)}$ is preferably $-CH_2-SiX_aR^3_{(3-a)}$ or $-CH_2-CH_2-CH_2-SiX_aR^3_{(3-a)}$. In such a case, it is possible to further increase the curing speed of the polyester ether type polymer (S1).

In a case where the polyester ether type polymer (S1) has a plurality of $R^2$ in its molecule, such a plurality of

$R^2$ may be the same or different. That is, when t is an integer of from 2 to 8, each $R^2$ independently represents a bivalent organic group.

In the above formula (1), $R^3$ is a monovalent organic group having from 1 to 20 carbon atoms, preferably a monovalent organic group having from 1 to 6 carbon atoms. Specifically, it may, for example, be a methyl group, an ethyl group, a propyl group, a butyl group or a pentyl group.

$R^3$ may have a substituent. Such a substituent may, for example, be a methyl group or a phenyl group.

In a case where the polyester ether type polymer (S1) has a plurality of $R^3$ in its molecule, such a plurality of $R^3$ may be the same or different from one another. That is, when a is 1, each of two $R^3$ bonded to one silicon atom (Si) independently represents a monovalent organic group having from 1 to 20 carbon atoms, which may have a substituent.

In the formula (1), X represents a hydroxy group (-OH) or a hydrolyzable group. The hydrolyzable group may, for example, be a -OR group (wherein R is a hydrocarbon group having at most 4 carbon atoms). Such a -OR group is preferably an alkoxy or alkenyloxy group having at most 4 carbon atoms. Specifically, it may, for example, be a methoxy group, an ethoxy group, a propoxy group or a propenyloxy group. Among them, a methoxy group or an ethoxy group is more preferred. In such a case, it is possible to further improve the curing speed of the polyester ether type polymer (S1).

In the polyester ether type polymer (S1), in a case where a plurality of X are present in its molecule, such a plurality of X may be the same or different from one another. That is, in the formula (1), when a is 2 or 3, and/or t is an integer of from 2 to 8, each of the plurality of X independently represents a hydroxy group or a hydrolyzable group.

Further, in the formula (1), a represents an integer of from 1 to 3. When t is an integer of from 2 to 8, each of the t pieces of a independently represents an integer of from 1 to 3. a is preferably 2 or 3, most preferably 3.

In the above formula (1), $-SiX_aR^3_{(3-a)}$ is preferably a trimethoxysilyl group or a triethoxysilyl group, particularly preferably a trimethoxysilyl group, whereby the storage stability of the silyl group-containing polymer (S) will be good, and the curing speed of the curable composition will be high, such being preferred for the production of the adherence substance.

It is considered that in the present invention, an urethane bond and the above silyl group are close to each other in the molecule, whereby a low adhesive strength of the adherence substance can be obtained, and the stability of the adhesive strength can be obtained.

In the above formula (1), Y represents a bivalent group (A) or a bivalent group (B).

Specifically, in a case where a first initiator (z1) made of a poly(mono)ol having no oxyalkylene group is used as the initiator (z), the bivalent group (A) is a group derived from a cyclic ester compound (a) used for the production of the poly(mono)ol (p1) as an intermediate, and the bivalent group (B) is a group derived from an alkylene oxide (b) used for the production of the poly(mono)ol (p1). In a case where a second initiator (z2) made of a polyoxyalkylene poly(mono)ol having an oxyalkylene group is used as the initiator (z), Y in the above formula (1) contains also a bivalent group (B) derived from such an initiator (z2). The cyclic ester compound (a), the alkylene oxide (b), the first initiator (z1) and the second initiator (z2) will be described hereinafter.

In a case where the polymer (S) has a plurality of Y in its molecule, such a plurality of Y may be the same or different from one another. That is, when r is an integer of from 2 to 1,000 and/or when t is an integer of from 2 to 8, each of Y independently is a bivalent group (A) or a bivalent group (B).

In the above formula (1), r represents an integer of from 1 to 1,000. This r is preferably an integer of from 10 to 500, more preferably an integer of from 20 to 200. Here, when t is from 2 to-8, each r independently represents an integer of from 1 to 1,000.

In the above formula (A), $R^4$ represents an alkylene group having from 2 to 8 carbon atoms. In order to make sure that the melting point will not be too high, $R^4$ is preferably an alkylene group having from 2 to 5 carbon atoms, and among them, it is more preferably a linear saturated hydrocarbon chain. In a case where the polymer (S) has a plurality of bivalent groups (A) in its molecule, a plurality of $R^4$ in the plurality of bivalent groups (A) may be the same or different. $R^4$ is most preferably a n-pentylene group.

In the above formula (B), $R^5$ represents an alkylene group having from 2 to 4 carbon atoms. From the viewpoint of the viscosity of the polymer (S), $R^5$ is preferably an ethylene group and/or a propylene group, more preferably only a propylene group. In a case where the polymer (S) has a plurality of bivalent groups (B) in its molecule, a plurality of $R^5$ in the plurality of bivalent groups (B) may be the same or different from one another.

In the polyester ether type polymer (S1), a copolymer chain of the bivalent group (A) and bivalent group (B), constituting the polyester ether chain represented by $-(Y-)_r$, may be a random copolymer chain or a block copolymer chain, and both the random copolymer and the block copolymer chain may be present in one molecule. Further, in a case where t is 2 or more and a plurality of polyester ether chains are present in the molecule, the sequential order of the bivalent group (A) and the bivalent group (B) in such a plurality of polyester ether chains may be the same or different. Such copolymer chains of the bivalent group (A) and the bivalent group (B) preferably have random copolymer chains, and it is preferred that both a random copolymer chain and a block copolymer chain are present in one molecule.

In the polyester ether type polymer (S1), the mass ratio of the bivalent group (A) and the bivalent group (B) i.e. (A):(B) is preferably from 5:95 to 95:5. A more preferred range is from 30:70 to 70:30. A particularly preferred range

is from 30:70 to 60:40. When the ratio of (A):(B) is within the above range, the viscosity will be low, and the adhesion to the substrate will be good.

That is, the adhesion to the substrate can be made good by introducing the bivalent group (A). Further, the viscosity of the curable composition can be made low by introducing the bivalent group (B). Further, by introducing the bivalent group (B), it is possible to obtain an adherence substance excellent in flexibility. Thus, it is considered that so-called zipping tends to hardly occur at the time of peeling the adherence substance from the adherend. Further, it is considered that by introducing the bivalent group (B), it is possible to lower the surface resistance of the adherence substance and to suppress the peel electrostatic charge.

<PROCESS FOR PRODUCING POLYESTER ETHER TYPE POLYMER S1>

The polyester ether type polymer (S1) can be produced by a process comprising a first step of reacting an initiator (z) made of a compound having from 1 to 8 hydroxy groups in its molecule with a cyclic ester compound (a) having from 3 to 9 carbon atoms and an alkylene oxide (b) having from 2 to 4 carbon atoms in the presence of a polymerization catalyst to obtain a polyester ether poly(mono)ol (p1), and a second step of reacting the poly(mono)ol (p1) with a silyl isocyanate compound (i) in the presence of an urethane-forming catalyst to obtain a polyester ether type silyl group-containing polymer (s1).

[FIRST STEP]

<INITIATOR (z)>

The initiator (z) to be used in the first step is a compound having from 1 to 8 hydroxy groups in the molecule. The initiator (z) may be a first initiator (z1) which has from 1 to 8 hydroxy groups in the molecule and which has no oxyalkylene group in the molecule, or a second initiator (z2) made of a polyoxyalkylene poly(mono)ol obtainable by reacting the first initiator (z1) with an alkylene oxide.

In a case where the first initiator (z1) or a second initiator (z2) is used as the initiator (z), $R^1$ in the above formula (1) corresponds to the-residue obtained by removing all hydroxy groups from the first initiator (z1).

In a case where the first initiator (z1) is used as the initiator (z), $-(Y)_r-O-$ in the formula (1) derives from the cyclic ester compound (a) and the alkylene oxide (b), polymerized with the first initiator (z1). In a case where the second initiator (z2) is used as the initiator (z), $-(Y)_r-O-$ in the formula (1) derives from the alkylene oxide polymerized with the first initiator (z1) at the time of producing the second initiator (z2), and the cyclic ester compound (a) and alkylene oxide (b) polymerized with the second initiator (z2).

The number (t) of hydroxy groups in the initiator (z) corresponds to t in the polyester ether type polymer (S1) of the above formula (1) obtained by using the initiator (z). The number (t) of hydroxy groups in the second initiator (z2) corresponds to the number (t) of hydroxy groups in the first initiator (z1) used for its production.

A specific example of the first initiator (z1) may, for example, be a monohydric alcohol such as methanol, ethanol, 2-propanol, n-butanol, iso-butanol, 2-ethylhexanol, decyl alcohol, lauryl alcohol, tridecanol, cetyl alcohol, stearyl alcohol or oleyl alcohol; water; a dihydric alcohol such as ethylene glycol, diethylene glycol, propylene glycol, dipropylene glycol, 1,3-propanediol, 1,4-cyclohexanediol, 1,3-butanediol, 1,4-butandiol, 1,6-hexanediol or 1,4-cyclohexanediol; a polyhydric alcohol such as glycerol, diglycerol, trimethylolpropane, pentaerythritol, dipentaerythritol or tripentaerythritol; a saccharide such as glucose, sorbitol, dextrose, fructose, sucrose or methyl glycoside, or a derivative thereof; or a phenol compound such as bisphenol A, bisphenol F, bisphenol S, novolac, resol or resorcin.

The second initiator (z2) preferably has an average hydroxy value of from 20 mgKOH/g to 280 mgKOH/g. Its number average molecular weight (Mn) is preferably from 400 to 5,000, more preferably from 700 to 2,000. When such Mn is at least the lower limit within the above range, good physical properties can be obtained, and when it is at most the upper limit, it is possible to maintain the viscosity to be low.

The second initiator (z2) preferably has a molecular weight distribution (Mw/Mn) of at most 3.0, more preferably at most 2.0. when the molecular weight distribution of the second initiator (z2) is within the above range, and the content of the portion derived from the second initiator (z2) is adjusted to be at least 50 mass% in the poly(mono)ol (p1), the molecular weight distribution (Mw/Mn) of the poly(mono)ol (p1) can be made to be at most 1.4. When the molecular weight distribution of the poly(mono)ol (p1) is made small, it is possible to lower the viscosity of the poly(mono)ol (p1). Accordingly, it is possible to lower the viscosity of the polyester ether type polymer (S1).

The second initiator (z2) is preferably a polyoxyalkylene poly(mono)ol (z21) represented by the following formula (4) from the viewpoint of easy production.

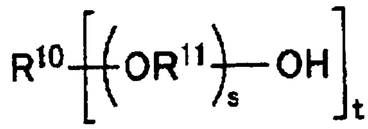 (4)

In the above formula (4), $R^{10}$ represents a t-valent hydrocarbon group having from 1 to 20 carbon atoms, $R^{11}$ represents an alkylene group having from 2 to 4 carbon atoms, t represents an integer of from 1 to 8, and s represents an integer of from 1 to 250.

In a case where a plurality of $R^{11}$ are present in its molecule, such a plurality of $R^{11}$ may be the same or different from one another. That is, when s is an integer of from 2 to 250, and/or when t is an integer of from 2 to 8, each $R^{11}$ independently represents an alkylene group having from 2 to 4 carbon atoms. When t is from 2 to 8, t pieces of the monovalent groups bonded to $R^{10}$ may be the same or different from one another. That is, when t is from 2 to 8, each s independently represents an integer of from 1 to 250.

When the number of carbon atoms in $R^{10}$ is at most 20, the melting point will be low, and the production will be easy. Such $R^{10}$ is preferably a t-valent hydrocarbon group having from 1 to 10 carbon atoms.

When s is an integer of at most 250, the viscosity is low, and the handling is easy. Such s is preferably an integer of from 5 to 100.

In the above formula (4), $R^{10}$ is a residue derived from the first initiator (z1) used for the production of the polyoxyalkylene poly(mono)ol (z21). That is, it is a residue obtained by removing all hydroxy groups from the first initiator (z1). In the formula (4), t corresponds to the number (t) of hydroxy groups in the first initiator (z1) employed. The number (t) of hydroxy groups in the polyoxyalkylene poly(mono)ol (z21) corresponds to t in the polyester ether type polymer (S1) of the above formula (1) which is obtained by using the polyoxyalkylene poly(mono)ol (z21) as the initiator (z).

<POLYESTER ETHER TYPE SILYL GROUP-CONTAINING POLYMER (S11)>

When a polyoxyalkylene poly(mono)ol (z21) represented by the above formula (4) is used as the initiator (z), it is possible to obtain a polyester ether type silyl group-containing polymer represented by the following formula (2) (hereinafter sometimes referred to as a polyester ether type polymer (S11)) via the second step.

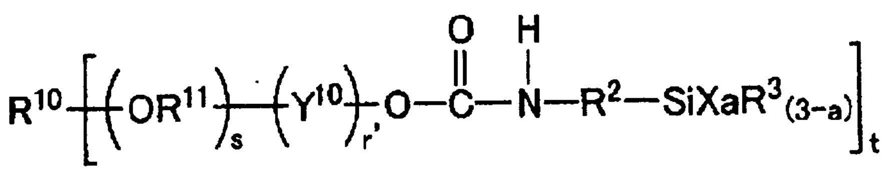 (2)

In the above formula (2), $R^{10}$ represents a t-valent hydrocarbon group having from 1 to 20 carbon atoms, $R^{11}$ represents an alkylene group having from 2 to 4 carbon atoms, derived from the above-mentioned polyoxyalkylene poly (mono)ol (z2), $R^2$ represents a bivalent organic group, $R^3$ represents a monovalent organic group having from 1 to 20 carbon atoms, X represents a hydroxy group or a hydrolyzable group, $Y^{10}$ represents a bivalent group represented by the above formula (A) derived from the cyclic ester compound (a), or a bivalent group represented by the above formula (B) derived from the alkylene oxide (b), a represents an integer of from 1 to 3, r' represents an integer of at least 1, s represents an integer of from 1 to 250, and the sum of r' and s is an integer of from 2 to 1,000, and t represents an integer of from 1 to 8.

When t is from 2 to 8, t pieces of the monovalent groups bonded to $R^{10}$ may be the same or different from one another. When a is 2 or 3, two or three X bonded to one silicon atom may be the same or different from one another. When a is 1, two $R^3$ bonded to one silicon atom may be the same or different from each other. When r' is 2 or more, a plurality of $Y^{10}$ bonded to one another may be the same or different. When s is 2 or more, the plurality of $-OR^{11}-$ bonded to one another may be the same or different from one another.

In the formula (2), $R^2$, $R^3$, X, a and t are the same as $R^2$, $R^3$, X, a and t in the above formula (1), including the preferred embodiment. $R^{10}$, $R^{11}$ and s are the same as $R^{10}$, $R^{11}$ and s in the above formula (4), including the preferred embodiment.

$Y^{10}$ is a bivalent group (A) derived from the after-mentioned cyclic ester compound (a) or a bivalent group (B) derived from the after-mentioned alkylene oxide (b).

In the formula (2), r' is an integer of at least 1, and the sum of r' and s (r'+s) is an integer of from 2 to 1,000,

preferably an integer of from 5 to 200, more preferably an integer of from 10 to 100.

Such a polyester ether type polymer (S11) has a merit that it is excellent in the handling efficiency, since it has a low viscosity.

With respect to the initiator (z), one type may be used alone, or two or more types may be used in combination. Further, initiators different in the number (t) of hydroxy groups may be used in combination.

<CYCLIC ESTER COMPOUND (a)>

The cyclic ester compound (a) to be used in the first step is one having from 3 to 9 carbon atoms.

A preferred example may be β-propiolactone (3 carbon atoms), δ-valerolactone (5 carbon atoms) or ε-caprolactone (6 carbon atoms). Among them, ε-caprolactone is preferred. When the cyclic ester compound (a) is ε-caprolactone, a bivalent group (A) wherein $R^4$ is a n-pentylene group will be formed when it undergoes ring opening during the polymerization.

The cyclic ester compound (a) may be a monomer, a dimer or a trimer. From the viewpoint of the reactivity, it is preferably a monomer. With respect to the cyclic ester compound (a), one type may be used alone, or two or more types may be used in combination.

<ALKYLENE OXIDE (b)>

The alkylene oxide (b) to be used in the first step is one having from 2 to 4 carbon atoms. Its specific example may, for example, be ethylene oxide, propylene oxide, 1,2-butylene oxide, 2,3-butylene oxide or oxetane.

With respect to the alkylene oxide (b), one type may be used alone, or two or more types may be used in combination.

Among the above examples, it is preferred to use at least one type selected from ethylene oxide and propylene oxide.

When the alkylene oxide (b) is ethylene oxide, a bivalent group (B) wherein $R^5$ is an ethylene group is formed by its ring opening during the polymerization. Further, when the alkylene oxide (b) is propylene oxide, a bivalent group (B) wherein $R^5$ is a propylene group, is formed by its ring opening during the polymerization.

<POLYMERIZATION CATALYST>

In the first step, a polymerization catalyst is used at the time of copolymerizing the initiator (z) with the cyclic ester compound (a) and the alkylene oxide (b). Such a polymerization catalyst is not particularly limited. However, specifically, it may, for example, be (1) a composite metal cyanide complex catalyst, or (2) a catalyst of a compound having a P=N bond represented by a hydroxide salt of a phosphazenium cation. It is more preferred to employ a composite metal cyanide complex catalyst.

By using a neutral composite metal cyanide complex catalyst in the first step, it is possible to control the hydrolysis of the cyclic ester compound (a), whereby a polyester ether poly(mono)ol (p1) can be obtained in good yield. Further, the composite metal cyanide complex catalyst has a high activity, and when the composite metal cyanide complex catalyst is used in the first step, the polyester ether poly(mono)ol (p1) obtainable in such a first step tends to have a large molecular weight. A polyester ether type silyl group-containing polymer (S1) obtainable by using such a polyester ether poly(mono)ol (p1) having a large molecular weight has a merit such that it is excellent in the curability, and the cured product of the curable composition will be excellent in the mechanical property such as elongation.

Further, when the composite metal cyanide complex catalyst is used in the first step, the copolymerization reaction rate can be increased, and it is possible to obtain a polyester ether poly(mono)ol (p1) having a high molecular weight with a narrow molecular weight distribution. A polyester ether type silyl group-containing polymer (S1) obtainable by using the poly(mono)ol (p1) having a high molecular weight with a narrow molecular weight distribution, has a low viscosity and thus has a merit such that it is excellent in the operation efficiency such as the handling efficiency.

[(1) COMPOSITE METAL CYANIDE COMPLEX CATALYST]

The composite metal cyanide complex catalyst is preferably a complex having zinc hexacyanocobaltate as the main component, because of its high polymerization activity. The composite metal cyanide complex catalyst preferably has an organic ligand. It is more preferred that the organic ligand is, for example, an ether or an alcohol, since a high activity is thereby obtainable.

As the ether as the above organic ligand, it is preferred to employ at least one member selected from ethylene glycol dimethyl ether (glyme), diethylene glycol dimethyl ether (diglyme) and triethylene glycol dimethyl ether. Among them, glyme is more preferred from the viewpoint of the handling efficiency of the complex during the polymerization

reaction.

As the alcohol as the above organic ligand, it is preferred to use tert-butyl alcohol or a mixture of tert-butyl alcohol with at least one member selected from the group consisting of n-butyl alcohol, sec-butyl alcohol, iso-butyl alcohol, tert-pentyl alcohol, iso-pentyl alcohol, N,N-dimethylacetamide and ethylene glycol mono-tert-butyl ether, whereby the polymerization catalyst becomes more active, and the amount of the polymerization catalyst can be reduced, and consequently, the amount of the catalyst remaining in the polyester ether poly(mono)ol (p1) can be reduced.

Particularly by using tert-butyl alcohol, it is possible to increase the copolymer reaction rate with the cyclic ester compound (a) with the alkylene oxide (b), and it is possible to obtain a polyester ether poly(mono)ol (p1) having a narrow molecular weight distribution.

The amount of the composite metal cyanide complex catalyst is preferably from 1 to 500 ppm based on the total mass of the obtainable polyester ether poly(mono)ol (p1). It is more preferably from 1 to 100 ppm, whereby the storage stability of the product will be excellent, and it is economically advantageous.

Further, in a case where the amount of the composite metal cyanide complex catalyst remaining in the polyester ether poly(mono)ol (p1) is large, an operation to remove the composite metal cyanide complex catalyst from the obtained poly(mono)ol (p1) may be carried out after completion of the first step. Otherwise, without removing the composite metal cyanide complex catalyst, the second step may be carried out as it is.

On the other hand, in a case where the amount of the composite metal cyanide complex catalyst remaining in the polyester ether poly(mono)ol (p1) is small and will not adversely affect the subsequent step, it is possible to proceed to the next step without carrying out a step of removing the composite metal cyanide complex catalyst. In such a case, the number of steps can be reduced by reducing the composite metal cyanide complex catalyst, whereby it is possible to increase the production efficiency of the polyester ether poly(mono)ol (p1). Such a composite metal cyanide complex catalyst can be produced by a known production method.

[(2) COMPOUND CATALYST HAVING P=N BOND]

The compound catalyst having P=N bond may, for example, be (2-1) a phosphazenium compound , (2-2) a phosphazene compound or (2-3) a phosphine oxide compound.

The phosphazenium compound may, for example, be a compound disclosed in JP-A-11-106500. Specifically, it may, for example, be tetrakis[tris(dimethylamino)phosphoranylideneamino]phosphonium hydroxide, tetrakis[tris(dimethylamino)phosphoranylideneamino]phosphonium methoxide, tetrakis[tris(dimethylamino)phosphoranylideneamino]phosphonium ethoxide or tetrakis[tri(pyrrolidin-1-yl)phosphoranylideneamino]phosphonium-tert-butoxide.

(2-2) The phosphazene compound may, for example, be a compound disclosed in JP-A-10-36499. Specifically, it may, for example, be 1-tert-butyl-2,2,2-tris(dimethylamino)phosphazene, 1-(1,1,3,3-tetramethylbutyl)-2,2,2-tris (dimethylamino)phosphazene, 1-ethyl-2,2,4,4,4-pentakis(dimethylamino)-2$\lambda^5$,4$\lambda^5$-catenadi (phosphazene), 1-tert-butyl-4,4,4-tris(dimethylamino)-2,2-bis[tris(dimethylamino)phosphoranylideneamino]-2$\lambda^5$,4$\lambda^5$-catenadi (phosphazene), 1-(1,1,3,3- tetramethylbutyl)- 4,4,4- tris (dimethylamino)- 2,2- bis [tris (dimethylamino) phosphoranylideneamino]- 2$\lambda^5$, 4$\lambda^5$-catenadi (phosphazene), 1-tert-butyl-2,2,2-tri(1-pyrrolidinyl)phosphazene or 7-ethyl-5,11-dimethyl-1,5,7,11-tetraaza-6$\lambda^5$-phosphaspiro[5,5]undeca-1 (6)-ene.

(2-3) The phosphine oxide compound may, for example, be a compound disclosed in JP-A-11-302371. Specifically, it may, for example, be tris([tris(dimethylamino)phosphoranylideneamino]phosphine oxide or tris[tris(diethylamino)phosphoranylideneamino]phosphine oxide.

Among them, it is preferred to employ (2-1) a phosphazenium compound or (2-3) a phosphine oxide compound from the viewpoint of availability.

In a case where the above compound catalyst having P=N bond is used as a polymerization catalyst, its amount is such that the compound catalyst having P=N bond is preferably from $1\times10^{-4}$ to $5\times10^{-1}$ mol equivalent, more preferably from $1\times10^{-4}$ to $2\times10^{-1}$ mol equivalent, per mol equivalent of active hydrogen atoms i.e. mol equivalent of hydroxy groups, in the initiator (z).

When the amount of the compound catalyst having P=N bond is at least $1\times10^{-4}$ mol equivalent, per mol equivalent of active hydrogen atoms in the initiator (z), the copolymerization reaction rate of the cyclic ester compound (a) with the alkylene oxide (b) can be well accelerated, and when it is at most $5\times10^{-1}$ mol equivalent, such is preferred to suppress the production cost.

Further, in a case where (2) the compound catalyst having P=N bond is used as the polymerization catalyst in the first step, if the catalyst remains in the polyester ether poly(mono)ol (p1), such a poly(mono)ol (p1) tends to be colored, and therefore, it is preferred to remove the catalyst component after the production of the poly(mono)ol (p1).

<PRODUCTION OF POLYESTER ETHER POLY(MONO)OL (p1)>

In the first step, the initiator (z) is reacted with the cyclic ester compound (a) and the alkylene oxide (b) in the

presence of the polymerization catalyst to obtain a polyester ether poly(mono)ol (p1).

The types and amounts of the cyclic ester compound (a) and the alkylene oxide (b) used in the first step are suitably set depending upon the adhesive properties of the adherence substance obtainable by curing the curable composition. When the ester chain derived from the bivalent group (A) is increased, the adhesion to the substrate will be improved. When the ether chain derived from the bivalent group (B) is increased, an adherence substance rich in flexibility can be obtained.

In a case where two or more initiators (z) different in the number (t) of hydroxy groups are to be used, such two or more imitators (z) may be mixed and then reacted with the cyclic ester compound (a) and the alkylene oxide (b). Otherwise, the respective initiators (z) may be reacted with the cyclic ester compound (a) and the alkylene oxide (b) to obtain poly(mono)ols (p1), which may then be mixed.

It is preferred to mix a monool (p1) obtained by using an initiator (z) having one hydroxy group, with a polyol (p1) obtained by using an initiator (z) having two or more hydroxy groups, from the viewpoint of the adjustment of the physical properties and the viscosity.

In a case where a first initiator (z1) is used as the initiator (z), the copolymer chains of the bivalent group (A) and the bivalent group (B) in the polyester ether type polymer (S1) derive from the copolymer chains of the cyclic ester compound (a) and the alkylene oxide (b) in the polyester ether poly(mono)ol (p1).

Further, in a case where the second initiator (z2) is used as the initiator, the block chains made of $-(OR^{11}-)_s$ in the above formula (2), and the copolymer chains of the cyclic ester compound (a) and the alkylene oxide (b), bonded to the block chains, will be the copolymer chains of the bivalent group (A) and the bivalent group (B) in the polyester ether type polymer (S1).

A random copolymer of the polyester ether poly(mono)ol (p1) can be obtained by carrying out polymerization by simultaneously adding at least one type of the alkylene oxide (b) and at least one type of the cyclic ester compound (a) into the reactor in the presence of the initiator (z) and the polymerization catalyst (random copolymerization).

Otherwise, a block copolymer of the polyester ether poly(mono)ol (p1) can be obtained by sequentially adding at least one type of the alkylene oxide (b) and at least one type of the cyclic ester compound (a) (block copolymerization).

Further, it is possible to obtain a polyester ether poly(mono)ol wherein random copolymer moieties and block copolymer moieties are present in the same molecule by adjusting the addition order and amounts of the cyclic ester compound (a) and the alkylene oxide (b) to introduce the polyester chain moiety derived from the cyclic ester compound (a) and/or the polyoxyalkylene chain moiety to parts in the molecule (random-block copolymer).

For example, by simultaneously adding a cyclic ester polymer having at least one cyclic ester compound (a) preliminarily polymerized in a predetermined amount, and an alkylene oxide (b) polymer having at least one alkylene oxide preliminarily polymerized in a predetermined amount, it is possible to introduce block copolymer chains in the molecule of a polyester ether poly(mono)ol (p1).

In a case where the polyester ether poly(mono)ol (p1) has random copolymer chains, the content of the random copolymer chains of the cyclic ester compound (a) and the alkylene oxide (b) in the polyester ether poly(mono)ol (p1), is preferably from 10 to 95 mass%, more preferably from 20 to 90 mass%. The content of random copolymer chains is the proportion of random copolymer chains obtained by simultaneously adding the cyclic ester compound (a) and the alkylene oxide (b), in the polyester ether poly(mono)ol. It is calculated from the total amount of the cyclic ester compound (a) and the alkylene oxide (b) simultaneously added, based on the total mass of the produced polyester ether poly(mono) ol. When the content of random copolymer chains is at least 10 mass%, sufficient curability of the polyester ether type silyl group-containing polymer (S1) can easily be obtained, and when it is at most 95 mass%, the viscosity of the polyester ether poly(mono)ol (p1) can be suppressed at a low level, whereby the handling efficiency will be good.

The content of the bivalent group (A) represented by the above formula (A) derived from the cyclic ester compound (a) is preferably from 5 to 50 mass%, more preferably from 5 to 40 mass%, in the polyester ether poly(mono) ol (p1) obtained in the first step. When the content of such a bivalent group (A) is at least 5 mass%, sufficient curability of the polyester ether type silyl group-containing polymer (S1) can easily be obtained, and the wettability of the cured product tends to be good. When it is at most 50 mass%, the viscosity of the polyester ether poly(mono)ol (p1) is likely to be low.

In order to bring the content of the bivalent group(a) to be from 5 to 50 mass%, it is preferred to adjust the proportion of the cyclic ester compound (a) occupying in the total mass of the initiator (z), the cyclic ester compound (a) and the alkylene oxide (b) used in the polymerization reaction, to be from 5 to 50 mass%.

The content of the bivalent group (B) represented by the above formula (B) is preferably from 50 to 95 mass%, more preferably from 60 to 95 mass%, in the polyester ether poly(mono)ol (p1) obtained in the first step.

In a case where the first initiator (z1) is used as the initiator (z) in order to bring the content of the bivalent group (B) to be from 50 to 95 mass%, it is preferred to adjust the proportion of the alkylene oxide (b) occupying in the total mass of the cyclic ester compound (a) and the alkylene oxide (b) used for the polymerization reaction, to be from 5 to 95 mass%. When such a content is at least 50 mass%, the viscosity of the polyester ether poly(mono)ol (p1) can easily be made low, and when it is at most 95 mass%, sufficient durability of the polyester ether type silyl group-containing

polymer (S1) can easily be obtained.

Further, in a case where the second initiator (z2) is used as the initiator (z), in order to bring the content of the bivalent group (B) to be from 50 to 95 mass%, it is preferred to bring the proportion of the total mass of the oxyalkylene group contained in the second initiator (z2) and the alkylene oxide (b), occupying in the total mass of the initiator (z), the cyclic ester compound (a) and the alkylene oxide (b) used for the polymerization reaction, to be from 50 to 95 mass%.

Further, it is preferred to adjust the mass ratio of the bivalent group (B) derived from the alkylene oxide (b) to the bivalent group (A) derived from the cyclic ester compound (a), present in the polyester ether poly(mono)ol (p1) obtained in the first step, to be within a range of the molar ratio (A):(B) in the above polyester ether type polymer (S1).

There is no particularly restriction with respect to the production conditions for the polyester ether poly(mono)ol (p1), i.e. the stirring efficiency, the supply rates of the cyclic ester compound (a) and the alkylene oxide (b), the reaction temperature, and the presence or absence of the solvent, and the production conditions may be suitably set depending upon the production efficiency or the physical properties of the desired polyester ether poly(mono)ol (p1).

In the first step, addition of the cyclic ester compound (a) and the alkylene oxide (b) into the reactor may be an addition from a liquid phase or addition from a gas phase.

The polyester ether poly(mono)ol (p1) obtained in the first step has an average hydroxy value (OHV) of preferably from 10 to 230 mgKOH/g, more preferably from 20 to 120 mgKOH/g, further preferably from 30 to 60 mgKOH/g.

When the average hydroxy value is at least 10 mgKOH/g, the viscosity will be low, and the handling will be easy, and when it is at most 230 mgKOH/g, flexibility and strength can be provided.

The polyester ether poly(mono)ol (p1) obtained in the first step has a number average molecular of preferably from 500 to 10,000, more preferably from 1,000 to 5,000, further preferably from 1,000 to 3,000.

When the number average molecular weight of the polyester ether poly(mono)ol (p1) is at least 500, the number of cyclic ester units can be sufficiently existed, whereby sufficient curability of the polyester ether type silyl group-containing polymer (S1) can easily be obtained, and sufficient stickiness can be obtained on the surface of the cured product. When the number average molecular weight of the poly(mono)ol (p1) is at most 10,000, the viscosity of the polyester ether poly(mono)ol (p1) can be made sufficiently low.

The molecular weight distribution (Mw/Mn) of the polyester ether poly(mono)ol (p1) is preferably at most 2.0, more preferably from 1.02 to 1.4, further preferably from 1.02 to 1.35. When the molecular weight distribution is at most 2.0, the viscosity of the polyester ether poly(mono)ol (p1) can easily be made low. When the molecular weight distribution of the polyester ether poly(mono)ol (p1) is at least 1.02, the time required for the polymerization reaction tends to be short, such being preferred from the viewpoint of the improvement of the production efficiency.

[SECOND STEP]

In the second step, a polyester ether type silyl group-containing polymer (S1) is synthesized from the polyester ether poly(mono)ol (p1) obtained in the first step. Such a polyester ether type polymer (S1) is obtained by reacting the polyester ether poly(mono)ol (p1) with a silyl isocyanate compound (i) in the presence of an urethane-forming catalyst.

[SILYL ISOCYANATE COMPOUND (i)]

The silyl isocyanate compound (i) is represented by the following formula (5).

$$OCN\text{-}R^2\text{-}SiXaR^3_{(3\text{-}a)} \qquad (5)$$

$R^2$, $R^3$ and a in this formula have the same meanings as $R^2$, $R^3$ and a in the above formula (1) including the preferred embodiments. Further, X represents a hydrolyzable group in the definition of X in the above formula (1). $-R^2\text{-}SiX_aR^3{}_{(3\text{-}a)}$ in the above formula (1) derives from $-R^2\text{-}SiX_aR^3{}_{(3\text{-}a)}$ in the silyl isocyanate compound (i) represented by the above formula (5).

The silyl isocyanate compound (i) may, for example, be an isocyanate silane compound such as α-isocyanate methyl trimethoxysilane, β-isocyanate ethyl trimethoxysilane, γ-isocyanate propyl trimethoxysilane, γ-isocyanate butyl trimethoxysilane, γ-isocyanate pentyl trimethoxysilane, α-isocyanate methyl triethoxysilane, β-isocyanate ethyl triethoxysilane, γ-isocyanate propyl triethoxysilane, γ-isocyanate butyl triethoxysilane, γ-isocyanate pentyl triethoxysilane, α-isocyanate methyl methyl dimethoxysilane, α-isocyanate ethyl ethyl dimethoxysilane, α-isocyanate propyl trimethoxysilane or α-isocyanate propyl triethoxysilane. Among them, γ-isocyanate propyl trimethoxysilane or γ-isocyanate propyl triethoxysilane is preferred.

(URETHANE-FORMING CATALYST)

In the present invention, an urethane-forming catalyst is used at the time of reacting the polyester ether poly(mono)ol (p1) with the silyl isocyanate compound (i). As such an urethane-forming catalyst, a known urethane-forming reaction catalyst may be employed. Specifically, a tin catalyst such as dibutyltin dilaurate (DBTDL), or a bismuth catalyst may be mentioned. Further, a composite metal cyanide complex catalyst or the like may be used. Such a composite metal cyanide complex catalyst is the same as the composite metal cyanide complex catalyst as described in the first step.

In a case where a composite metal cyanide complex catalyst is to be used, it is possible to employ the same composite metal cyanide complex catalyst as the polymerization catalyst used in the first step. That is, the polyester ether poly(mono)ol (p1) may be reacted with the silyl isocyanate compound (i) in the presence of the composite metal cyanide complex used in the first step, to obtain a polyester ether type silyl group-containing polymer (S1).

In such a case, it is preferred that the amount or the activity of the composite metal cyanide complex catalyst used in the first step is adjusted so that the activity of the composite metal cyanide complex catalyst remains at the completion of the first step, and the second step is carried out as it is. By such a method, the reaction can be proceeded in the second step without adding an urethane-forming catalyst afresh. Further, the first step and the second step can continuously be carried out, whereby the operation efficiency will be improved, and the yield of the obtained polyester ether type polymer (S1) may also be improved.

The amount of the urethane-forming catalyst to be used in the second step is not particularly limited, so long as it is an amount required for the urethane-forming reaction of the polyester ether poly(mono)ol (p1) with the silyl isocyanate compound (i). It is preferably at most 100 ppm, more preferably at most 50 ppm, based on the total mass (finish mass) of the polyester ether type polymer (S1) obtained by this reaction. When the amount of the urethane-forming catalyst is at most 100 ppm, the residual amount of the urethane-forming catalyst in the polyester ether type polymer (S1) is little, whereby good storage stability can easily be obtained.

In the urethane-forming reaction of the polyester ether poly(mono)ol (p1) with the silyl isocyanate compound (i), the reaction temperature and the time required until the completion of the reaction, vary depending upon the amount of the urethane-forming catalyst, but it is usually preferred to carry out the reaction at a temperature of from 20 to 200˚C, preferably from 50 to 150˚C, for a few hours. Further, this reaction is preferably carried out in an inert gas such as nitrogen gas or argon gas. In such a case, it is possible to suppress a side reaction, whereby it is possible to improve the yield of the obtainable silyl group-containing polymer.

With respect to the blend ratio of the polyester ether poly(mono)ol (p1) to the silyl isocyanate compound (i) in the second step, the molar ratio represented by NCO/OH i.e. the ratio of the number of isocyanate groups (NCO) of the silyl isocyanate compound (i) to the number of hydroxy groups (OH) of the polyester ether poly(mono)ol (p1), is preferably at most 1.1, more preferably at most 1.0, further preferably at most 0.97.

When the NCO/OH (molar ratio) is within the above range, hydroxy groups of the polyester ether poly(mono) ol (p1) tend to easily remain after the urethane-forming reaction. That is, in addition to the polyester ether type-polymer (S1) represented by the above formula (1), a hydroxy group-remaining polymer (S1-OH) having OH groups bonded to some of $R^1$-[-(Y-)r-]$_t$ in the above formula (1) is likely to be easily formed. It is considered that the presence of such a hydroxy group-remaining polymer (S1-OH) having OH groups in its molecule, contributes to the effects of the present invention.

The lower limit of the NCO/OH (molar ratio) is preferably 0.3, more preferably 0.5, further preferably 0.8, from the viewpoint of the storage stability.

The reaction product obtained by carrying out the urethane-forming reaction as described above, mainly contains the polyester ether type silyl group-containing polymer (S1) and further contains a hydroxy group-remaining polymer (S1-OH) wherein hydroxy groups of the polyester ether poly(mono)ol (p1) substantially remain as unreacted.

The curable composition containing such a polyester ether type silyl group-containing polymer (S1) has a low viscosity and good coatability. Accordingly, good coatability can be obtained even without using a solvent, whereby the curable composition can be made solvent-free at the time of forming an adherence substance. Further, such a composition is excellent in curability, and when contacted with moisture, it undergoes curing (moisture curing) quickly and firmly to present a cured product. For such moisture curing, the reactive silicon group ($-SiX_aR^3_{(3-a)}$) will contribute. Further, when it is applied on a substrate and cured, good adhesion to the substrate can be obtained. The cured product after the curing has good flexibility, good surface wettability and a low adherence property. Thus, it is suitable as an adherence substance layer, which has good wettability and adhesion to the adherend and at the same time has good removability.

Especially, the polyester ether type polymer (S11) obtained by using the polyoxyalkylene poly(mono)ol (z21) in the first step, has a lower viscosity and is excellent in handling efficiency.

Further, by using the silyl isocyanate compound (i) represented by the above formula (5) in the second step, it is possible to easily produce a polyester ether type polymer (S1) by a small number of steps. For comparison, a method may, for example, be mentioned wherein a polyisocyanate compound having no silyl group is reacted with a polyester ether poly(mono)ol (p1) under such a condition that the isocyanate group is in excess, and then the isocyanate groups remaining at the terminals of the polyester ether poly(mono)ol (p1) are converted to silyl groups.

By adopting the second step, the process time can substantially be shortened, and impurities produced by a side reaction during the production process can be reduced. Accordingly, it is possible to make the obtainable polyester

ether type silyl group-containing polymer (S1) to be excellent in the storage stability. Further, a cumbersome operation of e.g. purification may also be omitted.

<POLYETHER TYPE SILYL GROUP-CONTAINING POLYMER (S2)>

The polyether type polymer (S2) is the same as the polyester ether type polymer (S1) except that Y in the above formula (1) consists only of bivalent groups (B).

<PROCESS FOR PRODUCING POLYETHER TYPE SILYL GROUP-CONTAINING POLYMER (S2)>

The polyether type silyl group-containing polymer (S2) can be produced via a first step of producing a polyether poly(mono)ol (p2) (hereinafter sometimes referred to as a poly(mono)ol (p2)) represented by $R^1$-[-$(Y)_r$-OH$]_t$ (wherein Y is a bivalent group represented by the above formula (B)), and a second step of reacting the poly(mono)ol (p2) with a silyl isocyanate compound (i) in the presence of an urethane-forming catalyst.

[FIRST STEP]

The polyether poly(mono)ol (p2) can be produced by a known method. For example, it can be produced by [1] a method of reacting an initiator (z) made of a compound having from 1 to 8 hydroxy groups in its molecule with an alkylene oxide (b) having from 2 to 4 carbon atoms in the presence of a polymerization catalyst.

The initiator (z) and the alkylene oxide (b) are the same as the initiator (z) and the alkylene oxide (b) in the process for producing the above-mentioned polyester ether type polymer (S1), respectively. The first initiator (z1) may be used, or the second initiator (z2) may be used.

As the method of reacting the initiator (z) with the alkylene oxide (b) to obtain the poly(mono)ol (p2), a known method may be employed. As the polymerization catalyst, a known catalyst may suitably be employed. The polymerization catalyst may be an alkali catalyst such as an alkali metal hydroxide, or may be the above-mentioned composite metal cyanide complex catalyst. The composite metal cyanide complex catalyst is more preferred.

Or, [2] the poly(mono)ol (p2) may, for example, be a polyoxytetramethylene glycol. The polyoxytetramethylene glycol can be produced by ring-opening polymerization of THF. The poly(mono)ol (p2) is also available from commercial products.

The polyether poly(mono)ol (p2) has a number average molecular weight of preferably from 500 to 15,000, more preferably from 700 to 5,000. When the number average molecular weight is at least the lower limit within the above range, good physical properties can be obtained, and when it is at most the upper limit, the viscosity can be maintained to be low.

The molecular weight distribution (Mw/Mn) of the poly(mono)ol (p2) is preferably at most 3, more preferably from 2.8 to 1.5, further preferably from 2.5 to 1.8. When the molecular weight distribution is at most 3, the viscosity of the poly(mono)ol (p2) can easily be made sufficiently low. When the molecular weight distribution of the poly(mono)ol (p2) is at least 1.5, the time required for the polymerization reaction can be made short, such being preferred from the viewpoint of improvement of the production efficiency.

The average hydroxy value of the polyether poly(mono)ol (p2) is preferably from 15 to 230 mgKOH/g, more preferably from 20 to 170 mgKOH/g. When the average hydroxy value is at least 15 mgKOH/g, good physical properties can be obtained, and when it is at most 230 mgKOH/g, the viscosity can be maintained to be low.

[SECOND STEP]

The second step is the same as the second step in the above-mentioned process for producing the polyester ether type polymer (S1).

In the second step, the blend ratio of the polyether poly(mono)ol (p2) to the silyl isocyanate compound (i) is the same as NCO/OH (molar ratio) in the above-mentioned method for producing the polyester ether type polymer (S1).

Like the case of the above polyester ether type polymer (S1), the reaction product obtained by the urethane-forming reaction in the second step mainly contains the polyether type silyl group-containing polymer (S2) and further contains the hydroxy group-remaining polymer (S2-OH) wherein hydroxy groups of the polyether poly(mono)ol (p2) substantially remain as unreacted.

Also a curable composition containing such a polyether type silyl group-containing polymer (S2) has a low viscosity, undergoes moisture curing at room temperature quickly and firmly and presents good adhesion to a substrate. Thus, it is suitable as a curable composition to obtain an adherence substance. Further, a cured product after the curing has good flexibility and has good surface wettability and a low adherence property. Therefore, it is suitable as an adherence substance layer, which has good wettability and adhesion to an adherend and has good removability.

<POLYESTER TYPE SILYL GROUP-CONTAINING POLYMER (S3)>

The polyester type polymer (S3) is the same as the polyester ether type polymer (S1) except that Y in the above formula (1) consists only of the bivalent group (A).

<PROCESS FOR PRODUCING POLYESTER TYPE SILYL GROUP-CONTAINING POLYMER (S3)>

The polyester type silyl group-containing polymer (S3) can be produced via a first step of producing a polyester poly(mono)ol (p3) (hereinafter sometimes referred to as a poly(mono)ol (p3)) represented by $R^1$-[-$(Y)_r$-OH$]_t$ (wherein Y is a bivalent group represented by the above formula (A)), and a second step of reacting the poly(mono)ol (p3) with the silyl isocyanate compound (i) in the presence of an urethane-forming catalyst.

[FIRST STEP]

The polyester poly(mono)ol (p3) can be produced by a known method. It is also available from commercial products.

The polyester poly(mono)ol (p3) has a number average molecular weight of preferably from 500 to 15,000, more preferably from 700 to 5,000. When the number average molecular weight is at least 500, good physical properties can be obtained, and when it is at most 15,000, the viscosity can be maintained to be low.

The molecular weight distribution (Mw/Mn) of the poly(mono)ol (p3) is preferably at most 3, more preferably from 2.8 to 1.5, further preferably from 2.5 to 1.8. When the molecular weight distribution is at most 2, the viscosity of the poly(mono)ol (p2) can be easily made to be sufficiently low. When the molecular weight distribution of the poly(mono)ol (p3) is at least 1.5, the time required for the polymerization reaction tends to be short, such being preferred from the viewpoint of improvement of the production efficiency.

The average hydroxy value of the polyether poly(mono)ol (p3) is preferably from 15 to 230 mgKOH/g, more preferably from 20 to 170 mgKOH/g. When the average hydroxy value is at least 15 mgKOH/g, good physical properties can be obtained, and when it is at most 230 mgKOH/g, the viscosity can be maintained to be low.

The second step is the same the second step in the above-mentioned process for producing the polyester ether type polymer (S1).

In the second step, the blend ratio of the polyether poly(mono)ol (p3) to the silyl isocyanate compound (i) is the same as NCO/OH (molar ratio) in the above-mentioned process for producing the polyester ether type polymer (S1).

Like the case of the above polyester ether type polymer (S1), the reaction product obtained by the urethane-forming reaction in the second step mainly contains the polyester type silyl group-containing polymer (S3) and further contains the hydroxy group-remaining polymer (S3-OH) wherein hydroxy groups of the polyether poly(mono)ol (p3) substantially remain as unreacted.

Also a curable composition containing such a polyester type silyl group-containing polymer (S3) has a low viscosity, undergoes moisture curing at room temperature quickly and firmly and presents good adhesion to a substrate. Thus, it is suitable as a curable composition to obtain an adherence substance. Further, a cured product after the curing has good flexibility and has good surface wettability and a low adherence property. Therefore, it is suitable as an adherence substance layer, which has good wettability and adhesion to an adherend and provides good removability.

The silyl group-containing polymer (S) contained in the curable composition of the present invention may be any one of the polyester ether type polymer (S1), the polyether type polymer (S2) and the polyester type polymer (S3), or a combination of two of them, or may contain three of them. In a case where two or more of them are used in combination, they may be mixed after producing the polyester ether type polymer (S1), the polyether type polymer (S2) and the polyester type polymer (S3) respectively, or the poly(mono)ols (p1), (p2) and/or (p3) as their intermediates may be mixed and then such a mixture may be reacted with the silyl isocyanate compound (i).

Further, in each of the polyester ether type polymer (S1), the polyether type polymer (S2) and the polyester type polymer (S3), one type may be used alone or two or more types may be used in combination.

In a case where two members selected from the polyester ether type polymer (S1), the polyether type polymer (S2) and the polyester type polymer (S3) are used as mixed, the mixing ratio is preferably within a range of from 95:5 to 5:95 by mass ratio.

<ANOTHER SILYL GROUP-CONTAINING POLYMER (S4)>

The curable composition of the present invention may contain a silyl group-containing polymer (S4) represented by the following formula (3) as an optional component (hereinafter sometimes referred to as another polymer (S4)).

$$R^{21}\left[\left(Y'\right)_k R^{22}-SiX'_{a'}R^{23}_{(3-a')}\right]_m \quad (3)$$

In the formula (3), $R^{21}$ represents a m-valent residue obtained by removing all hydroxy groups from a compound having m pieces of hydroxy groups in the molecule; $R^{22}$ represents a bivalent organic group; $R^{23}$ represents a monovalent organic group having from 1 to 20 carbon atoms; X' is a hydroxy group or a hydrolyzable group; Y' represents an oxyalkylene group having from 2 to 4 carbon atoms; a' represents an integer of from 1 to 3; k represents an integer of from 1 to 10,000; m represents an integer of from 1 to 8; when m is from 2 to 8, m pieces of monovalent groups bonded to $R^{21}$ may be the same or different from one another; when a' is 2 or 3, 2 or 3 pieces of X' bonded to one silicon atom may be the same or different from one another; when a is 1, 2 pieces of $R^{23}$ bonded to one silicon atom may be the same or different from each other; and when k is 2 or more, the plurality of Y' bonded to one another, may be the same or different from one another.

In the above formula (3), $R^{21}$ is the same as $R^1$ in the above formula (1), $R^{22}$ as $R^2$, $R^{23}$ as $R^3$, X' as X, Y' as Y, a' as a and m as t, respectively, including the preferred embodiments.

In the formula (3), k represents an integer of from 1 to 10,000. Such k is preferably an integer of from 1 to 1,000, more preferably an integer of from 10 to 1,000. Further, when m is from 2 to 8, each k independently represents an integer of form 1 to 10,000.

Such another polymer (S4) can be produced by a known production method. It is also available from commercial products.

In the curable composition of the present invention, by incorporating another polymer (S4) in addition to the polymer (S), the wettability of the curable composition may be improved.

The blend amount of another polymer (S4) is preferably at least 5 parts by mass per 100 parts by mass of the silyl group-containing polymer (S) (including the hydroxy group-remaining polymer) in order to obtain a sufficient effect of its addition. The upper limit is preferably at most 70 parts by mass from the viewpoint of the viscosity for coating. A more preferred range of the blend amount of such another polymer (S4) is from 10 to 70 parts by mass.

In the curable composition of the present invention, urethane bonds and silyl groups are present substantially in equal amounts, or silyl groups are contained in a larger amount than urethane bonds, because urethane bonds derive from the silyl isocyanate compound (i), and silyl groups derive from the silyl isocyanate compound (i) and another polymer (S4). Here, "substantially in equal amounts" means containing the premise that the silyl isocyanate compound (i) used for the preparation of the curable composition is a high purity product. An industrially available silyl isocyanate compound (i) has more or less undergone a condensation of silyl groups with one another by an influence of e.g. moisture or a modification of isocyanate groups (modification such as hydrolytic modification or isocyanurate condensation modification). In the present invention, the ratio of urethane bonds to silyl groups is preferably from 1/1 to 1/2, more preferably from 1/1 to 2/3, by molar ratio of urethane bonds/silyl groups. Within such a ratio, the adherence substance obtainable by curing the curable composition will have a low adhesive strength and will be excellent in the stability of the adhesive strength.

<ADDITIVES>

The curable composition of the present invention may contain additives. In the curable composition, it is preferred not to use a plasticizer. Particularly, it is preferred not to use an ester type plasticizer such a dioctyl phthalate. The reason is that if an ester type plasticizer is employed, the adhesive strength between the cured product and the substrate tends to be low, and an adhesive deposit is likely to result.

[CURING AGENT]

The curable composition of the present invention is cured by contact with water. Accordingly, it reacts with water in the atmosphere to undergo moisture curing. Otherwise, immediately before the curing, water ($H_2O$) may be added as a curing agent. In such a case, the amount of water is preferably from 0.01 to 5 parts by mass, more preferably from 0.01 to 1 part by mass, particularly preferably from 0.05 to 0.5 part by mass, per 100 parts by mass of the total amount of the polymer (S) and another polymer (S4) (including the hydroxy group-remaining polymer). By adjusting the amount of the curing agent to be at least 0.01 part by mass, the curing can effectively be promoted, and by adjusting the amount of the curing agent to be at most 5 parts by mass, the working time in use can be secured.

[CURING CATALYST]

It is preferred to incorporate a curing catalyst (a curing accelerator) to accelerate the hydrolysis and/or crosslinking reaction of the reactive silicon groups in the polymer (S) and another polymer (S4).

As such a curing catalyst, a known catalyst may suitably be used as a component to accelerate the reaction of reactive silicon groups. Specifically, it may, for example, be an organic tin carboxylate such as dibutyltin diacetate, dibutyltin dilaurate, dioctyltin dilaurate, $(n\text{-}C_4H_9)_2Sn(OCOCH{=}CHCOOCH_3)_2$, $(n\text{-}C_4H_9)_2Sn(OCOCH{=}CHCOO(n\text{-}C_4H_9))_2$, $(n\text{-}C_8H_{17})_2Sn(OCOCH{=}CHCOOCH_3)_2$, $(n\text{-}C_8H_{17})_2Sn(OCOCH{=}CHCOO(n\text{-}C_4H_9))_2$ or $(n\text{-}C_8H_{17})_2Sn(OCOCH{=}CHCOO(iso\text{-}C_8H_{17}))_2$; a sulfur-containing organic tin compound such as $(n\text{-}C_4H_9)_2Sn(SCH_2COO)$, $(n\text{-}C_8H_{17})_2Sn(SCH_2COO)$, $(n\text{-}C_8H_{17})_2Sn(SCH_2CH_2COO)$, $(n\text{-}C_8H_{17})_2Sn(SCH_2COOCH_2CH_2OCOCH_2S)$, $(n\text{-}C_4H_9)_2Sn(SCH_2COO(iso\text{-}C_8H_{17}))_2$, $(n\text{-}C_8H_{17})_2Sn(SCH_2COO(iso\text{-}C_8H_{17}))_2$, $(n\text{-}C_8H_{17})_2Sn(SCH_2COO(n\text{-}C_8H_{17}))_2$ or $(n\text{-}C_4H_9)_2SnS$; an organic tin oxide such as $(n\text{-}C_4H_9)_2SnO$ or $(n\text{-}C_8H_{17})_2SnO$; a reaction product of an ester compound selected from the group consisting of ethyl silicate, dimethyl maleate, diethyl maleate, dioctyl maleate, dimethyl phthalate, diethyl phthalate and dioctyl phthalate, with the above-mentioned organic tin oxide; a chelate tin compound such as $(n\text{-}C_4H_9)_2Sn(acac)_2$, $(n\text{-}C_8H_{17})_2Sn(acac)_2$, $(n\text{-}C_4H_9)_2Sn(OC_8H_{17})(acac)$, $(n\text{-}C_4H_9)_2Sn(OC(CH_3)CHCO_2C_2H_5)_2$, $(n\text{-}C_8H_{17})_2Sn(OC(CH_3)CHCO_2C_2H_5)_2$, $(n\text{-}C_4H_9)_2Sn(OC_7H_{17})(OC(CH_3)CHCO_2C_2H_5)$ or bisacetyl acetonate tin (where the above acac means an acetylacetonate ligand, and $OC(CH_3)CHCO_2C_2H_5$ means an ethyl acetoacetate ligand); a reaction product of an alkoxysilane selected from the group consisting of tetramethoxysilane, tetraethoxysilane and tetrapropoxysilane, with the above chelate tin compound; or an organic tin compound containing a -SnOSn- bond, such as $(n\text{-}C_4H_9)_2(CH_3COO)SnOSn(OCOCH_3)(n\text{-}C_4H_9)_2$ or $(n\text{-}C_4H_9)_2(CH_3O)SnOSn(OCH_3)(n\text{-}C_4H_9)_2$.

Further, specific examples of the curing catalyst include a bivalent tin carboxylate such as tin 2-ethyl hexanoate, tin n-octylate, tin naphthenate or tin stearate; a metal salt other than a tin salt of an organic carboxylic acid such as octylic acid, oleic acid, naphthenic acid or stearic acid; a calcium carboxylate, a zirconium carboxylate, an iron carboxylate, a vanadium carboxylate, a bismuth carboxylate such as bismuthtris-2-ethyl hexanoate, a lead carboxylate, a titanium carboxylate or a nickel carboxylate; a titanium alkoxide such as tetraisopropyl titanate, tetrabutyl titanate, tetramethyl titanate or tetra(2-ethylhexyl titanate); an aluminum alkoxide such as aluminum isopropylate or mono-sec-butoxyaluminum diisopropylate; a zirconium alkoxide such as zirconium n-propylate or zirconium n-butyrate; a titanium chelate such as titanium tetraacetylacetonate, titanium ethylacetoacetate, titanium octylene glycolate or titanium lactate; an aluminum chelate such as aluminum trisacetylacetonate, aluminum trisethylacetoacetate, or diisopropoxy aluminum ethylacetoacetate; a zirconium compound such as zirconium tetraacetylacetonate, zirconium bisacetylacetonate, zirconium acetylacetonate bisethyl actoacetate or zirconium acetate; an acidic compound such as phosphoric acid, p-toluenesulfonic acid or phthalic acid; an aliphatic monoamine such as butylamine, hexylamine, octylamine, decylamine or laurylamine; an aliphatic diamine such as ethylenediamine or hexanediamine; an aliphatic polyamine such as diethylenetriamine, triethylenetetramine or tetraethylenepentamine; a heterocyclic amine such as piperidine, piperazine or 1,8-diazabicyclo (5.4.0)udecene-7; an aromatic amine such as metaphenylenediamine, an alkanolamine such as monoethanolamine, diethanolamine or triethanolamine; a trialkylamine such as triethylamine; a primary to tertiary ammonium acid salt made of the above amine and an organic acid such as an aliphatic monocarboxylic acid (such as formic acid, acetic acid, octylic acid or 2-ethylhexanoic acid), an aliphatic polycarboxylic acid (such as oxalic acid, malonic acid, succinic acid, glutaric acid or adipic acid), an aromatic monocarboxylic acid (such as benzoic acid, toluic acid or ethylbenzoic acid), an aromatic polycarboxylic acid (such as phthalic acid, isophthalic acid, terephthalic acid, nitrophthalic acid or trimellitic acid), a phenol compound (such as phenol or resorcinol), a sulfonic acid compound (such as an alkyl benzenesulfonic acid, toluenesulfonic acid or benzenesulfonic acid) or a phosphoric acid compound, or an inorganic acid such as hydrochloric acid, hydrobromic acid or sulfuric acid; an ammonium hydroxide such as triethylmethylammonium hydroxide, trimethylbenzylammonium hydroxide, hexyltrimethylammonium hydroxide, octyltrimethylammonium hydroxide, decyltrimethylammonium hydroxide, dodecyltrimethylammonium hydroxide, octyldimethylethylammonium hydroxide, decyldimethylethylammonium hydroxide, dodecyldimethylethylammonium hydroxide, dihexyldimethylammonium hydroxide, dioctyldimethylammonium hydroxide, didecyldimethylammonium hydroxide or didodecyldimethylammonium hydroxide; and an amine compound such as various modified amine to be used as a curing agent for an epoxy resin.

These curing catalysts may be used alone or in combination as a mixture of two or more of them. In a case where two or more of them are combined, it is, for example, preferred to combine an aliphatic monoamine or another above-mentioned amine compound to the above-mentioned metal-containing compound such as a reaction product of the above-mentioned bivalent tin carboxylate, organic tin carboxylate or organic tin oxide with an ester compound, since it is thereby possible to obtain an excellent curability.

In a case where a curing catalyst is to be added, its amount is preferably from 0.001 to 10 parts by mass, more preferably from 0.01 to 5 parts by mass, per 100 parts by mass of the total amount of the polymer (s) and another polymer (S4) (including a hydroxy group-remaining polymer). When the amount of the curing catalyst is adjusted to be at least 0.001 part by mass, the curing speed can effectively be accelerated, and when the amount of the curing catalyst is adjusted to be at most 10 parts by mass, it is possible to secure a working time at the time of its use.

[SOLVENT]

The curable composition of the present invention has a low viscosity and can be applied without using any solvent, but it may contain a solvent.

Such a solvent is not particularly limited, and it may, for example, be an aliphatic hydrocarbon, an aromatic hydrocarbon, a halogenated hydrocarbon, an alcohol, a ketone, an ester, an ether, an ester alcohol, a ketone alcohol, an ether alcohol, a ketone ether, a ketone ester or an ester ether.

Among them, it is preferred to employ an alcohol as the solvent, since the storage stability of the curable composition can thereby be improved. Such an alcohol is preferably an alkyl alcohol having from 1 to 10 carbon atoms, more preferably methanol, ethanol, isopropanol, isopentyl alcohol or hexyl alcohol, further preferably-methanol or ethanol. Particularly when methanol is employed, if its amount is increased, the curing time of the curable composition can be prolonged. This is an effective technique to prolong a so-called pot life i.e. the time until the curable composition reaches the predetermined viscosity after its preparation.

In a case where a solvent is added to the curable composition, its amount is preferably at most 500 parts by mass, more preferably from 1 to 100 parts by mass, per 100 parts by mass of the total amount of the polymer (S) and another polymer (S4) (including a hydroxy group-remaining polymer). If the amount exceeds 500 parts by mass, shrinkage of the cured product may occur along with evaporation of the solvent.

[DEHYDRATING AGENT]

In order to improve the storage stability, the curable composition of the present invention may contain a small amount of a dehydrating agent within a range not to impair the effects of the present invention.

A specific example of such a dehydrating agent may, for example, be an alkyl orthoformate such as methyl orthoformate or ethyl orthoformate; an alkyl orthoacetate such as methyl orthoacetate or ethyl orthoacetate; a hydrolyzable organic silicon compound such as methyl trimethoxysilane, vinyl trimethoxysilane, tetramethoxysilane or tetraethoxysilane; or a hydrolyzable organic titanium compound. Among them, vinyl trimethoxysilane or tetraethoxysilane is preferred from the viewpoint of the cost and dehydrating ability.

In a case where a dehydrating agent is incorporated to the curable composition, its amount is preferably from 0.001 to 30 parts by mass, more preferably from 0.01 to 10 parts by mass, per 100 parts by mass of the total amount of the polymer (S) and another polymer (S4) (including a hydroxy group-remaining polymer).

[OTHER ADDITIVES]

The following filler, reinforcing agent, stabilizer, flame retardant, antistatic agent, release agent or antifungal agent may be incorporated to the curable composition. The filler or reinforcing agent may, for example, be carbon black, aluminum hydroxide, calcium carbonate, titanium oxide, silica, glass, bone meal, wood meal or fiber flakes.

The stabilizer may, for example, be an antioxidant, an ultraviolet absorber or a light-stabilizer.

The flame retardant may, for example, be a chloroalkyl phosphate, dimethylmethyl phosphonate, ammonium polyphosphate or an organic bromine compound.

The release agent may, for example, be wax, soap or silicone oil.

The antifungal agent may, for example, be pentachlorophenol, pentachlorophenol laurate or bis(tri-n-butyltin) oxide.

Further, to the curable composition, tackifiers may be added for the purpose of improving the adhesion to the substrate.

<ADHERENCE SUBSTANCE>

The curable composition of the present invention is obtained by mixing the silyl group-containing polymer (S), an optionally incorporated another polymer (S4) and additives which may be incorporated as the case requires.

Further, the adherence substance of the present invention is obtained by curing the above curable composition. Particularly, the present invention provides an adherence substance which is obtainable by curing a curable composition comprising a silyl group-containing polymer (S) and which has a peel adhesive strength of at most 1 N/25 mm, preferably more than 0 N/25 mm and at most 1 N/25 mm, particularly preferably from 0.005 to 0.8 N/25 mm. Further, the present invention provides an adherence substance obtainable by curing a curable composition containing a polyester ether type silyl group-containing polymer (S1) or a polyester type silyl group-containing polymer (S3).

<CURING OF CURABLE COMPOSITION>

The adherence substance of the present invention is obtainable by curing the above curable composition. The curable composition may be shaped after the curing. For example, the curable composition may be cured in a suitable form such as a sheet form and then shaped in a predetermined shape by e.g. die cutting, whereupon it can be used alone as an adherence substance. However, it is preferred that the curable composition is coated to a substrate, followed by curing to obtain a laminate.

The conditions for curing the curable composition may be set as the case requires. For example, one having a curable catalyst added, is prepared as the curable composition. A predetermined amount water is added as a curing agent thereto, followed by mixing thoroughly. The mixture is applied on a substrate. The applied thickness is suitably set. Thereafter, the coated substrate is heated in an oven and aged at room temperature, whereby the curable composition can be cured. It is also effective to leave it in a humidified environment at the time of aging at room temperature or after such aging. Heating by e.g. an oven is suitably set depending upon e.g. the heat resistance temperature of the substrate. For example, it is preferred to leave it in an environment of from 60 to 120˚C for from about 1 to 30 minutes Particularly in a case where a solvent is used, it is preferred to set a constant drying time. However, rapid drying is not desirable, since it causes foaming. Further, in the oven, or after taking it out from the oven, steam may be applied.

Application of the curable composition can be carried out continuously. That is, on a substrate taken out from a roll, the curable composition having a predetermined amount of water mixed, is applied and then heated and dried in an in-line oven. The obtained shaped product (laminate) is wound up if necessary, together with a separator. Such an wound up laminate is stored and aged in a humidified room temperature environment as the case requires to obtain a shaped adherence substance. In another application method, the substrate and the separator in the above method may be reversed. That is, application is initially made on the separator, and later, the substrate may be bonded.

<LAMINATE>

The present invention provides a laminate comprising at least one substrate layer and an adherence substance layer made of the adherence substance of the present invention. In a case where the laminate is in a sheet form, this laminate will be a pressure sensitive adhesive sheet. Otherwise, when the laminate is formed into a tape form, it will be a pressure sensitive adhesive tape.

Further, without using a substrate, on a separator which will be described later, the curable composition is applied and cured to form a cured product, whereupon the separator is peeled off, so that the adherence substance may be used alone. In such a case, a double coated pressure sensitive adhesive tape may, for example, be obtained. The curable composition of the present invention has a low viscosity and is excellent in coating properties even in a case where no solvent is employed Accordingly, good application is possible to the separator. Specifically, the curable composition is applied to the separator and heated and dried, and further, another separator is laminated thereon, followed by aging, to obtain a pressure sensitive adhesive sheet made of the adherence substance having no substrate. At that time, without using the another separator, winding is carried out by using the back side of the separator initially applied, whereby a roll of the adherence substance may be produced.

The laminate may have another layer, as the case requires. For example, an adhesive layer may be provided between the substrate layer and the adherence substance layer to prevent separating between the substrate and the adherence substance. Further, a buffer layer made of e.g. a foam may be provided between the substrate layer and the adherence substance layer. Otherwise, an electrically conductive material layer may be provided between the substrate layer and the adherence substance layer. Such an electrically conductive layer may be obtained by applying an electrically conductive material such as a metal type eclectically conductive material, an ionic electrically conductive material or a carbon type electrically conductive material on the substrate layer. The electrically conductive material may be applied alone or in combination with a binder such as various resins. Further, on the side of the adherence substance layer opposite to the substrate layer, a separator (release liner) layer may be provided. Further, on the side of the substrate layer opposite to the adherence substance layer, a print layer may be provided. When a print layer is provided, printing may be carried out, and the appearance may be improved. Further, an adherence substance layer may be formed on each side of the substrate layer. In this case, double coated pressure sensitive adhesive sheet may, for example, be obtained.

<SUBSTRATE>

The material for the substrate is not particularly limited. A preferred example may be a polyester such as polyethylene terephthalate (PET); a polyolefin such as polyethylene, polypropylene or a polyethylene/polypropylene copolymer (block copolymer or random copolymer); a halogenated polyolefin such as polyvinyl chloride; paper such as hard board; a cloth such as woven fabric or nonwoven fabric; or a metal foil such as an aluminum foil. These substrates

may be used in combination. For example, a laminate having a PET layer, a metal foil layer and a polyethylene layer laminated may be employed.

The surface of the substrate may not be processed beforehand. Even without carrying out preliminary processing, the surface of a polyester or paper bonded to the adherence substance layer becomes hardly separated by the adhesive effect along with the curing of the curable composition. A primer or the like may be applied, as the case requires.

On the other hand, in a case where a polyolefin is used as the substrate, it is preferred to preliminarily treat the surface to be coated with the curable composition, because the peel adhesive strength may sometimes become low with a non-treated surface. The preliminary treatment of the surface of the substrate made of a polyolefin to be coated with the curable composition, may, for example, be corona treatment (corona discharge treatment) or primer treatment. It is particularly preferred to carry out corona treatment, since the treatment is simple, and the process can be simplified.

For example, corona treatment may be carried out on one side of a polypropylene film having a thickness of 100 μm, and a curable composition is applied on this treated surface. After the application, heating and drying are carried out. With the film thus obtained, the side (the back side) having no adherence substance provided may be utilized as a separator, as it is. That is, this film may be wound up as it is to obtain a pressure sensitive adhesive film. That is, it can be wound up in a roll shape without interposing a separator.

<ADHERENCE SUBSTANCE LAYER>

In the pressure sensitive adhesive sheet or the like of the present invention, the thickness of the adherence substance layer is not particularly limited. For example, it is preferably at least 5 μm, more preferably at least 20 μm, further preferably at least 30 μm, from the viewpoint of the coating precision. From the viewpoint of the stability of the adhesive strength and economical efficiency, it is preferably at most 200 μm, more preferably at most 100 μm, further preferably at most 80 μm.

<SEPARATOR>

A separator may be laminated to an adhesive surface (the surface on which an adherend is bonded) of the above adherence substance layer. As such a separator, in addition to paper having the surface treated with a usual release agent, the above-mentioned non-treated polyolefin may be used. Otherwise, one having a polyolefin laminated on a substrate of paper or the like may also be used. By using a polyolefin as a separator, it is possible to prevent contamination by e.g. silicone oil. This is advantageous when the above pressure sensitive adhesive tape is used as a protective sheet for e.g. an electronic device. Further, when a polyolefin is used alone as a separator, recycling of the waste will be easy.

<APPLICATION OF PRESSURE SENSITIVE ADHESIVE SHEET>

By using the adherence substance of the present invention, it is possible to obtain a pressure sensitive adhesive sheet which provides particularly good wettability and adhesion to an adherend and which at the same time has a low adhesive strength and is excellent in removability. Further, it is possible to obtain a pressure sensitive adhesive sheet having a peel electrostatic charge suppressed and being excellent also in a high speed peeling property. Accordingly, the application of the pressure sensitive adhesive sheet may, for example, be for a protective sheet for automobiles; a protective sheet for electronic material such as electronic substrates, IC chips, etc.; a protective sheet for optical components such as polarizing plates, light diffusing plates, prism sheets, etc.; or a protective sheet for various displays. The pressure sensitive adhesive sheet of the present invention is particularly useful as a protective sheet to be peeled during the production process, such as a protective sheet for electronic materials or a protective sheet for optical components. That is, the adhesive strength is low and the removability is good, and at the same time the peel electrostatic charge is low, and the high speed peeling property is excellent.

Thus, the pressure sensitive adhesive sheet of the present invention is suitable as a protective pressure sensitive adhesive sheet for optical components. Particularly, the adherence substance of the present invention is excellent not only in flexibility but also in wettability. Therefore, even when unevenness is present on the surface of the adherend, good adhesion can be secured. Further, the protective pressure sensitive adhesive sheet of the present invention is excellent in adhesion so that no substantial displacement occurs in the adhesion area of the bonded adherend, and it has a low peel adhesive strength and can easily be peeled, such being useful for the improvement of the productivity in the process for producing liquid crystal panels, etc.

Therefore, the pressure sensitive adhesive sheet of the present invention is useful as a protective film for light diffusing plates or prism sheets, particularly as a protective film for their uneven surfaces. Further, an optical component having the pressure sensitive adhesive sheet of the present invention bonded, can be peeled with a low peel adhesive

strength, since the change with time of the adhesive strength of the adherence substance is small, and such a peel adhesive strength will not substantially change. Therefore, storage of an optical component for a long period of time will be possible.

Further, the pressure sensitive adhesive sheet of the present invention is useful also as a back grinding tape. The back grinding tape is a tape to protect the surface of a wafer during back grinding (grinding of the rear surface of a wafer) after forming a electronic circuit on a semiconductor wafer. The back grinding tape is bonded on the circuit surface to prevent a damage to the circuit surface or to prevent contamination of the wafer surface by penetration of grinding water or grinding dust. The pressure sensitive adhesive sheet of the present invention is excellent in adhesion so that displacement will not substantially occur in the adhesion area of the bonded adherend, but it has a low peel adhesive strength and can easily be peeled. Further, in a case where a polyolefin is used as the substrate, a separator is not required, and no contamination with e.g. silicone occur. Further, the peel electrostatic charge is suppressed, and a danger of damaging the circuit is little.

## EXAMPLES

Now, the present invention will be described in further detail with reference to Examples. However, it should be understood that the present invention is by no means restricted to such Examples.

In the following, propylene oxide will be abbreviated as PO, ethylene oxide as EO, ε-caprolacton as CL, γ-isocyanate propyl trimethoxysilane (content of isocyanate groups (NCO): 17.87 mass%) as TMS, and dibutyltin dilaurate as DBTDL. Further, as water, pure water was used. Further, as a stainless steel plate, a SUS-304 alloy plate defined in JIS was used. The surface of this stainless steel plate treated by bright annealing was substantially flat and glossy.

Silyl group-containing polymers used in Examples and Comparative Examples are ones prepared to have the compositions as identified in Table 1. Polyols used for the production of the silyl group-containing polymers are as follows. Further, the respective polyols as initiators used for the production of polyols A to D and F are ones obtained by reacting PO by using a KOH catalyst. The units of the amounts shown in Table 1 are "g" unless otherwise specified.

- Polyol A: A polyester ether polyol having an average hydroxy value of 56.1 mgKOH/g produced by reacting PO and CL so that the ratio of PO:CL would be 1:2 by mass ratio by using, as an initiator, a polyoxypropylene diol having an average hydroxy value of 160.3 mgKOH/g obtained by polymerizing PO with dipropylene glycol, and a composite metal cyanide complex catalyst (TBA-DMC catalyst obtained in Reference Preparation Example 1).
- Polyol B: A polyoxypropylene polyol having an average hydroxy value of 11.2 mgKOH/g produced by reacting PO by using, as an initiator, a polyoxypropylene diol having an average hydroxy value of 112 mgKOH/g obtained by polymerizing PO with dipropylene glycol, and a composite metal cyanide complex catalyst (TBA-DMC catalyst obtained in Reference Preparation Example 1).
- Polyol C: A polyoxypropylene polyol having an average hydroxy value of 56.1 mgKOH/g produced by reacting PO by using, as an initiator, a polyoxypropylene diol having an average hydroxy value of 280.5 mgKOH/g obtained by polymerizing PO with dipropylene glycol, and a KOH catalyst.
- Polyol D: A polyoxytetramethylene glycol (average molecular weight: 650), manufactured by Mitsubishi Chemical Corporation.
- Polyol E: P-1010, manufactured by Kuraray (copolymer of 3-methyl-1,5-pentanediol with adipic acid), a polyester polyol having an average hydroxy value of 112 mgKOH/g; average hydroxy value: 110.
- Polyol F: A polyoxypropylene polyol having an average hydroxy value of 5.6 mgKOH/g produced by reacting PO by using, as an initiator, a polyoxypropylene polyol (a mixture of a polyoxypropylene diol having an average hydroxy value of 37.4 mgKOH/g obtained by polymerizing PO with dipropylene glycol and a polyoxypropylene triol having an average hydroxy value of 33.7 mgKOH/g obtained by polymerizing PO with glycerol), and a composite metal cyanide complex catalyst (TBA-DMC catalyst obtained in Reference Preparation Example 1).

### REFERENCE PREPARATION EXAMPLE 1: Preparation of composite metal cyanide complex catalyst

By the following method, a zinc hexacyanocobaltate having tert-butyl alcohol as an organic ligand (hereinafter referred to as TBA-DMC catalyst) was prepared. In this Example, polyol X is a polyol having number average molecular weight ($Mn_1$) of 1,000, obtained by addition-polymerizing propylene oxide to dipropylene glycol.

Firstly, in a 500 ml flask, an aqueous solution comprising 10.2 g of zinc chloride and 10 g of water, was put, and while stirring this aqueous solution at 300 rpm and maintaining it at 40˚C, an aqueous solution comprising 4.2 g of potassium hexacyanocobaltate ($K_3[Co(CN)]_6$) and 75 g of water, was dropwise added over a period of 30 minutes. After completion of the dropwise addition, the mixture was further stirred for 30 minutes. Thereafter, a mixture comprising 40 g of ethylene glycol mono-tert-butyl ether (hereinafter abbreviated as EGMTBE), 40 g of tert-butyl alcohol (hereinafter abbreviated as TBA), 80 g of water and 0.6 of polyol X, was added to the above mixture, followed by stirring at 40˚C for

30 minutes and then at 60˚C for 60 minutes. The obtained reaction mixture was subjected to filtration over a period of 50 minutes by means of a circular filtration plate with a diameter of 125 mm and a quantitative filter paper for fine particles (No. 5C manufactured by ADVANTEC) under pressure (0.25 MPa) to separate solid.

Then, to this cake containing the composite metal cyanide complex, a mixture comprising 18 g of EGMTBE, 18 g of TBA and 84 g of water, was added, followed by stirring for 30 minutes, whereupon pressure filtration (filtration time: 15 minutes) was carried out. To the cake containing the composite metal cyanide complex obtained by the filtration, a mixture comprising 54 g of EGMTBE, 54 g of TBA and 12 g of water, was further added, followed by stirring for 30 minutes, to obtain an EGMTBE/TBA slurry containing the composite metal cyanide complex having an organic ligand. This slurry was used as TBA-DMC catalyst.

5 g of this slurry was taken into a flask, preliminarily dried in a nitrogen stream and then dried under reduced pressure at 80˚C for 4 hours. The obtained solid was weighed, whereby the concentration of the composite metal cyanide complex contained in this slurry was found to be 4.70 mass%.

PREPARATION EXAMPLE 1: Preparation of polyester ether type silyl group-containing polymer (S11-1)

[FIRST STEP]

Into a 10 L stainless steel pressure resistant reactor equipped with a stirrer, 2,800 g of a polyoxypropylene diol (hydroxy group-based Mw=700) as an initiator (z21) and TBA-DMC catalyst as a polymerization catalyst were introduced. The amount of the TBA-DMC catalyst was 50 ppm to the finish mass i.e. 50 ppm as the metal amount in the polymer upon completion of the first step.

After replacing the interior of the reactor with nitrogen, the temperature was raised to 140˚C, and 280 g of PO was introduced into the reactor with stirring and reacted. This is a step to activate TBA-DMC catalyst by initially supplying a small amount of PO.

Then, after the pressure in the reactor decreased, 1,640 g of PO and 3,280 g of CL were introduced into the reactor at constant rates, respectively, with stirring, so that the supply amounts per unit time would be PO/CL=1/2 by mass ratio. After completion of the introduction of PO and CL, the stirring was continued for further 1 hour. During that period, the temperature in the reactor was maintained to be 140˚C, and the stirring speed was maintained to be 500 rpm to let the polymerization reaction proceed, thereby to obtain polyol A.

The obtained polyol A was confirmed to have random copolymer chains of CL and PO from the results of measurement of $^{13}C$-NMR. This polyol A had an average hydroxy value of 56.1 mgKOH/g.

The content of the bivalent group (A) derived from CL, in the obtained polyol A, was 41 mass%. Further, the content of the random copolymer chains of CL and PO, in the polyol A, was 61.5 mass%.

[SECOND STEP]

To a four-necked flask equipped with a stirrer, a reflux condenser, a nitrogen-introducing tube, a thermometer and a dropping funnel, 658.9 g of the polyol A obtained as described above, and 150 g of TMS as a silyl isocyanate compound (i), were added, and DBTDL was added as an urethane-forming catalyst. The amount of DBTDL was adjusted to be an amount corresponding to 50 ppm to the total amount of the polyol A and TMS. And, the temperature was gradually raised to 80˚C, and a reaction was carried out until the peak of NCO by IR disappeared, to obtain a polyester ether type silyl group-containing polymer (S11-1). NCO/OH (molar ratio) of this urethane-forming reaction and Mw of the obtained polymer are shown in Table 1.

PREPARATION EXAMPLE 2: Preparation of polyether type silyl group-containing polymer (S2-1)

[FIRST STEP]

In a 10 L stainless steel pressure resistant reactor equipped with a stirrer, 800 g of a polyoxypropylenediol (hydroxy group-based Mw=1,000) as an initiator (z2) and TBA-DMC catalyst as a polymerization catalyst were introduced. The amount of TBA-DMC catalyst was 50 ppm to the finish mass.

After replacing the interior of the reactor with nitrogen, the temperature was raised to 140˚C, and 80 g of PO was introduced into the reactor with stirring and reacted. This is a step to activate TBA-DMC catalyst by initially supplying a small amount of PO.

Then, after the pressure in the reactor decreased, 7,120 g of PO was supplied with stirring and stirred for 11 hours while maintaining the stirring rate at 500 rpm and maintaining the temperature in the reactor at 140˚C thereby to let the polymerization reaction proceed, thereby to obtain polyol B.

[SECOND STEP]

A polyether type silyl group-containing polymer (S2-1) was obtained in the same manner as in Preparation Example 1 except that in the second step in Preparation Example 1, instead of the polyol A, the polyol B obtained as described above was used in an amount of 761.6 g, and the amount of TMS was changed to 15 g. The results are shown in Table 1.

PREPARATION EXAMPLE 3: Preparation of polyether type silyl group-containing polymer (S2-2)

[FIRST STEP]

In a 10 L stainless steel pressure resistant reactor equipped with a stirrer, 200 g of a polyoxypropylenediol (Mw=400) as an initiator (z2) and KOH as a polymerization catalyst were introduced. The amount of KOH was 0.3 mass% to the finish mass.
After replacing the interior of the reactor with nitrogen, the temperature was raised to 140˚C, and 960 g of PO was supplied with stirring, and stirred for 6 hours while maintaining the stirring rate at 500 rpm and while maintaining the temperature in the reactor at 140˚C to let the polymerization reaction proceed thereby to obtain polyol C.

[SECOND STEP]

A polyether type silyl group-containing polymer (S2-2) was obtained in the same manner as in Preparation Example 1 except that in the second step in Preparation Example 1, instead of the polyol A, the polyol C obtained as described above was used in an amount of 658.9 g. The results are shown in Table 1.

PREPARATION EXAMPLE 4: Preparation of polyether type silyl group-containing polymer (S2-3)

In this Example, polyol (D) was used.

[SECOND STEP]

A polyether type silyl group-containing polymer (S2-3) was obtained in the same manner as in Preparation Example 1 except that in the second step in Preparation Example 1, instead of the polyol A, the polyol D was used in an amount of 212.4 g. The results are shown in Table 1. PREPARATION EXAMPLE 5: Preparation of polyether type silyl group-containing polymer (S3-1)
In this Example, polyol E was used.

[SECOND STEP]

A polyester type silyl group-containing polymer (S3-1) was obtained in the same manner as in Preparation Example 1 except that in the second step in Preparation Example 1, instead of the polyol A, the polyol E was used in an amount of 333.4 g. The results are shown in Table 1. PREPARATION EXAMPLE 6: Preparation of another silyl group-containing polymer (S4-1)
A polymerization reaction was carried out under a condition of 120˚C while gradually adding 2,480 g of PO into a reactor in the presence of 1.2 g of a zinc hexacyanocobaltate-glyme complex catalyst by using, as an initiator, a mixture of 120 g of a polyoxypropylenediol (hereinafter referred to as diol 4A) having Mn=3,000 obtained by ring-opening polymerization of dipropylene glycol with propylene oxide (PO) and 200 g of a polyoxypropylenetriol (hereinafter referred to as triol 4B) having Mn=5,000 obtained by ring-opening polymerization of glycerol with PO, and after adding the entire amount of PO, the reaction was carried out until the internal pressure of the reactor no long decreased. Here, the zinc hexacyanocobaltate-glyme complex catalyst can be produced in Reference Preparation Example 1 by using glyme instead of EGMTBE and TBA.
Then, 120 g of diol 4A and 200 g of triol 4B were introduced into the reactor, and in the same manner as above, 1,680 g of PO was gradually added and then the reaction was carried out until the internal pressure of the reactor no longer decreased. Further, 120 g of diol 4A and 200 g of triol 4B were introduced into the reactor, and in the same manner as above, 1,280 g of PO was gradually added, and then, the reaction was carried out until the internal pressure of the reactor no long decreased. Further, 80 g of diol 4A and 130 g of triol 4B were introduced into the reactor, and further in the same manner as above, 590 g of PO was gradually added, and the reaction was carried out until the internal pressure of the reactor no long decreased.
Further, 60 g of diol 4A and 100 g of triol 4B were added, and in the same manner as above, 240 g of PO was

gradually added, and then, the reaction was carried out until the internal pressure of the reactor no longer decreased.

Finally, 75 g of diol 4A and 125 g of triol 4B were added, and in the same manner as above, 200 g of PO was gradually added, and then the reaction was carried out until the internal pressure of the reactor no long decreased. By this operation, a polyoxypropylenepolyol F having Mn of 17,000, Mw/Mn of 1.76 and a viscosity of 19.5 Pa·s (25˚C) was obtained.

To the obtained polyoxypropylenepolyol F, a methanol solution of sodium methoxide corresponding to 1.05 equivalent to hydroxy groups of polyol F, was added, and methanol was distilled off under reduced pressure under heating to convert terminal hydroxy groups of the polyoxypropylenepolyol to sodium alkoxide. Then, allyl chloride was reacted thereto, and then unreacted allyl chloride was removed, and further, a byproduct salt was removed by purification, to obtain a polyoxypropylene having terminal allyl groups. Further, methyldimethoxysilane was reacted thereto in the presence of a platinum catalyst to obtain an oxypropylene polymer (S4-1) having methyldimethoxysilyl groups at the terminals.

The obtained polymer (S4-1) had Mn of 20,000 and Mw/Mn of 1.35.

TABLE 1

| | | Silyl group-containing polymer | | | | |
|---|---|---|---|---|---|---|
| | | S11-1 | S2-1 | S2-2 | S2-3 | S3-1 |
| Polyol | A | 658.9 | | | | |
| | B | | 761.6 | | | |
| | C | | | 658.9 | | |
| | D | | | | 212.4 | |
| | E | | | | | 333.4 |
| Isocyanate | TMS | 150 | 15 | 150 | 150 | 150 |
| Catalyst for reaction | DBTDL (ppm) | 50 | 50 | 50 | 50 | 50 |
| Mw (GPC) | | 3,000 | 12,000 | 3,000 | 1,500 | 2,000 |
| NCO/OH | | 0.97 | 0.97 | 0.97 | 0.97 | 0.97 |

EXAMPLES 1 to 12

Curable compositions having formulations as identified in Tables 2 and 3 were prepared. The units for the blend amounts shown in Tables 2 and 3 are "g" unless otherwise specified. That is, a curing agent (water) and a curing catalyst were added to a silyl group-containing polymer to obtain a curable composition. As the curing catalyst, in Examples 1 to 11, #918 (manufactured by Sankyo Organic Chemicals Co., Ltd.) having a catalytic activity higher than DBTDL was used. Such #918 corresponds to a reaction product of an ester compound selected from the group consisting of diethyl phthalate and dioctyl phthalate, with an organic tin oxide. Further, in Example 12, SA102 (manufactured by SAN-APRO Ltd.) being an amine catalyst, was used. SA102 is an octylic acid salt of 1,8-diazabicyclo(5.4.0)undecene-7.

The obtained curable composition was applied on a PET film (substrate) having a thickness of 100 μm so that the layer thickness after drying would be 50 μm, and dried at 100˚C for 5 minutes in a circulation system oven. Then, after aging at 23˚C for 1 week, it was left to stand at 23˚C under a relative humidity of 65% for 2 hours to form an adherence substance layer thereby to obtain a pressure sensitive adhesive sheet.

Evaluations were carried out by the following methods. The evaluation results are shown in Tables 2 and 3.

(EVALUATION METHODS)

[VISCOSITY]

The viscosity of a curable composition was measured at 25˚C by means of rotor No. 1 by using E model viscometer RE-80U manufactured by TOKI SANGYO CO., LTD.

[COATABILITY (HANDLING)]

Judged from the viscosity of a curable composition and the stirring state at the time of preparing the curable

composition. As the viscosity at 25°C is high, the handling deteriorates. Thus, the viscosity being less than 10,000 mPa·s/25°C is evaluated to be ○ (good), and the viscosity being higher than that is evaluated to be × (no good).

[ADHESION STRENGTH TO SUBSTRATE]

A pressure sensitive adhesive sheet was bonded to a stainless steel plate treated by bright annealing, having a thickness of 1.5 mm, and aged for 1 week at 23°C under a relative humidity of 65%. Then, the pressure sensitive adhesive sheet was peeled, and the adhesion was judged from the state of the pressure sensitive adhesive. One peeled from the release surface (the interface between the adherence substance layer and the stainless steel plate) was judged to be ○ (good), and when peeled from a non-release surface (interface between the adherence substance layer and the PET film) or when the adhesive remained on the stainless steel plate, was judged to be × (no good).

[PEEL ADHESIVE STRENGTH]

A pressure sensitive adhesive sheet was bonded to a stainless steel plate treated by bright annealing, having a thickness of 1.5 mm, at room temperature and press-bonded by a rubber roll of 2 kg. Upon expiration of 30 minutes, the peel strength (180° peel at a tension speed of 300 mm/min) was measured by using a tensile testor (RTE-1210, manufactured by ORIENTEC CO., LTD.) prescribed in JIS B7721. It is shown the smaller this value, the lower the peel adhesive strength and the easier the peeling, and the removability is excellent.

[REMOVABILITY]

A pressure sensitive adhesive sheet was bonded to a stainless steel plate treated by bright annealing and then left to stand at 40°C under a relative humidity of 65% and cooled at 23°C under a relative humidity of 65%, and then peeled, whereupon the residual adhesive was visually evaluated. By the visual evaluation, one where no transfer of the adhesive to the stainless plate was observed was evaluated to be ○ (good), one where transfer of the adhesive was partially observed, was judged to be Δ (slightly good), and one where the adhesive was transferred completely was judged to be × (no good). Further, in a case where an adhesive remained on the stainless steel plate after peeling, the proportion of the adhesive deposit in the bonded area was calculated and evaluated by the following mathematical expression (I).

$$\text{Adhesive deposit(\%)} = (\text{area of the pressure sensitive adhesive transferred to the stainless steel plate/bonded area of the pressure sensitive adhesive sheet}) \times 100 \qquad (I)$$

[HOLDING POWER]

At one end of a stainless steel plate having a thickness of 1.5 mm and treated by bright annealing, a pressure sensitive adhesive sheet was bonded so that an area of 25 mm × 25 mm of the pressure sensitive adhesive sheet was in contact, and press-bonded by a roll. Then, the other end of the stainless steel plate was hanged, so that the pressure sensitive adhesive sheet was hanged from the stainless steel plate and left to stand at 23°C for 20 minutes. Thereafter, a load of 200 g was exerted to the pressure sensitive adhesive sheet, and the time in seconds until it was fallen, was measured. In a case where it was not fallen in 60 minutes, displacement upon expiration of 60 minutes was measured. Upon expiration of 60 minutes, one where no displacement was observed was evaluated to be ○ (good), and upon expiration of 60 minutes, one where displacement was observed or the sheet was fallen, was evaluated to be × (no good).

This holding power being good shows that the adhesion to the adherend is excellent.

[WETTABILITY]

A pressure sensitive adhesive sheet was cut out in a size of 25 mm in width × 15 cm in length; and one end of the sheet was bonded by 1 cm to a stainless steel plate treated by bright annealing, and the other end was lifted until 45° and then dropped. The time required from the dropping until the dropped pressure sensitive adhesive sheet adhered to the SUS plate, was measured. One where the time until the entire air trap disappeared, was within 10 seconds, was evaluated to be ○ (good), one where such a time exceeded 10 seconds was evaluated to be × (no good).

TABLE 2

| <Silyl group-containing polymer | Comp. Ex. 1 | Ex. 1 | Ex. 2 | Ex. 3 | Ex. 4 | Ex. 5 | Ex. 6 |
|---|---|---|---|---|---|---|---|
| S4-1 | 40 | 20 | | 20 | | | |
| S2-1 | | | 20 | | 20 | | 40 |
| S11-1 | | 20 | 20 | | | 20 | |
| S2-2 | | | | 20 | 20 | 20 | |
| S2-3 | | | | | | | |
| S3-1 | | | | | | | |
| Water as curing agent | 0.1 | 0.1 | 0.1 | 0.1 | 0.1 | 0.1 | 0.1 |
| Curing catalyst #918 | 0.4 | 0.4 | 0.4 | 0.4 | 0.4 | 0.4 | 0.4 |
| Curing catalyst SA-102 | | | | | | | |
| Layer thickness ($\mu$m) | 50 | 50 | 50 | 50 | 50 | 50 | 50 |
| Viscosity (mPa·s/25°C) | 14,000 | 8,500 | 5,000 | 4,400 | 2,900 | 1,700 | 7,100 |
| Coatability (handling) | × | ○ | ○ | ○ | ○ | ○ | ○ |
| Adhesion to PET substrate | × | ○ | ○ | ○ | ○ | ○ | ○ |
| 180° peel adhesive strength at a tension speed of 300 mm/min. upon expiration of 30 minutes after bonding (N/25 mm) | 0.21 | 0.17 | 0.06 | 0.08 | 0.06 | 0.04 | 0.08 |
| Removability | △10% | ○ | ○ | ○ | ○ | ○ | ○ |
| Holding power | ○ | ○ | ○ | ○ | ○ | ○ | ○ |
| Wettability | ○ | ○ | ○ | ○ | ○ | ○ | ○ |

TABLE 3

| <Silyl group-containing polymer | Ex. 7 | Ex. 8 | Ex. 9 | Ex. 10 | Ex. 11 | Ex. 12 |
|---|---|---|---|---|---|---|
| S4-1 | 20 | | 20 | | | |
| S2-1 | | 20 | | 20 | | 40 |
| S11-1 | | | | | 30 | |
| S2-2 | | | | | 10 | |
| S2-3 | 20 | 20 | | | | |
| S3-1 | | | 20 | 20 | | |
| Water as curing agent | 0.1 | 0.1 | 0.1 | 0.1 | 0.1 | 0.1 |
| Curing catalyst #918 | 0.4 | 0.4 | 0.4 | 0.4 | 0.4 | |
| Curing catalyst SA-102 | | | | | | 0.4 |
| Layer thickness ($\mu$m) | 50 | 50 | 50 | 50 | 50 | 50 |
| Viscosity (mPa·s/25°C) | 4,700 | 2,800 | 9,500 | 6,000 | 2,300 | 7,100 |
| Coatability (handling) | ○ | ○ | ○ | ○ | ○ | ○ |
| Adhesion to PET substrate | ○ | ○ | ○ | ○ | ○ | ○ |
| 180° peel adhesive strength at a tension speed of 300 mm/min. upon expiration of 30 minutes after bonding (N/25 mm) | 0.08 | 0.09 | 0.05 | 0.06 | 0.05 | 0.08 |

(continued)

| <Silyl group-containing polymer | Ex. 7 | Ex. 8 | Ex. 9 | Ex. 10 | Ex. 11 | Ex. 12 |
|---|---|---|---|---|---|---|
| Removability | ○ | ○ | ○ | ○ | ○ | ○ |
| Holding power | ○ | ○ | ○ | ○ | ○ | ○ |
| Wettability | ○ | ○ | ○ | ○ | ○ | ○ |

As shown in Tables 2 and 3, with the curable compositions in Examples, solvent-free application was possible. As compared with Comparative Example 1, the viscosity was low, and the curable compositions were superior in each of the coatability, the adhesion to the substrate, the holding power and the wettability, and the peel adhesive strength was also small.

Further, a surface roughened stainless steel plate was prepared by applying grinding with #280 to the surface of a stainless steel plate treated by bright annealing, having a thickness of 1.5 mm. By using the surface roughened stainless steel plate as an adherend, the removability, the holding power and the wettability were evaluated with respect to the pressure sensitive sheets obtained in Examples 1 to 6. The results were good in each case, and it was found that the adherence substance of the present invention shows good adhesive properties even on a roughened surface. Further, no adhesive deposit was observed upon peeling.

Also with respect to the pressure sensitive adhesive sheet obtained in Example 6, the peel electrostatic charge, surface resistance, volume specific resistance and high speed peel strength were evaluated by the following methods. The results are shown in Table 4.

As Comparative Example 2, with respect to a commercially available weakly adhesive type acrylic pressure sensitive adhesive, evaluations carried out in the same manner, and the above peel adhesive strength was measured (upon expiration of 30 minutes after bonding, tension speed: 300 mm/min). The results are shown in Table 4.

[PEEL ELECTROSTATIC CHARGE]

On a glass plate washed with methyl ethyl ketone and dried, a pressure sensitive adhesive sheet was bonded at room temperature and press-bonded by a rubber roll of 2 kg. 30 Minutes later, the pressure sensitive adhesive sheet was peeled under conditions of 180˚ peel and a tension speed of 30 m/min by means of a high speed peeling tester (product name; TE-701 model, manufactured by Tester Sangyo Co., Ltd.). On the surface of the pressure sensitive adhesive sheet immediately after peeling, a static electricity measuring apparatus (static electricity measuring apparatus KSD-0103, manufactured by Kasuga Electric Works Ltd.) was set, and the electrostatic charge (unit: V) was measured.

[SURFACE RESISTANCE]

The surface resistance (unit: Ω) was measured by using the adhesive surface of a pressure sensitive adhesive sheet. The measurement was carried out by using a high resistivity meter (HIRESTA-UP (MCP-HT450), manufactured by Mitsubishi Chemical Corporation) in a surface resistance mode at room temperature of 23˚C under a relative humidity of 65%. The smaller the value, the more difficult the static electrification.

[VOLUME SPECIFIC RESISTANCE]

The volume specific resistance (unit: Ω) was measured by using the adhesive surface of a pressure sensitive adhesive sheet. The measurement was carried out by using the above high resistivity meter in a volume specific resistance mode at room temperature of 23˚C under a relative humidity of 65%. The smaller the value, the more difficult the static electrification.

[HIGH SPEED PEELING PROPERTY]

On a SUS plate treated by bright annealing, washed methyl ethyl ketone and dried, a pressure sensitive adhesive sheet was bonded at room temperature and press-bonded by a rubber roll of 2 kg. Upon expiration of 24 hours, the SUS plate was placed and fixed on a table, and by using a high speed peeling tester (product name; TE-701 model, manufactured by Tester Sangyo Co., Ltd.), the pressure sensitive adhesive sheet was peeled by 180˚ peeling, whereby the peel adhesive strength was measured. The tension speed was at two levels of 300 mm/min and 30,000 mm/min (30 m/min).

TABLE 4

| | | Comparative Example 2 Acrylic pressure sensitive adhesive | Example 6 |
|---|---|---|---|
| Coatability (handling) | | ○ | ○ |
| Adhesion to PET substrate | | ○ | ○ |
| Peel adhesive strength | 180° peel adhesive strength at a tension speed of 300 mm/min. upon expiration of 30 minutes after bond (N/25 mm) | 0.24 | 0.08 |
| Removability | | × | ○ |
| Holding power | | ○ | ○ |
| Wettability | | × | ○ |
| Peel electrostatic charge (V) | | 800 | 200 |
| Surface resistance (Ω) | | $1\times10^{14}$ | $6\times10^{12}$ |
| Volume specific resistance (Ω) | | $1.2\times10^{12}$ | $2.4\times10^{9}$ |
| High speed peeling property | 180° peel adhesive strength at a tension speed of 300 mm/min. upon expiration of 24 hours after bonding (N/25 mm) | 0.24 | 0.08 |
| | 180° peel adhesive strength at a tension speed of 30,000 mm/min. upon expiration of 24 hours after bonding (N/25 mm) | 0.87 | 0.08 |

From the results in Table 4, it is evident that as compared with the acrylic pressure sensitive adhesive in Comparative Example, 2, the one in Example 6 had a small peel electrostatic charge, and its surface resistance (in Comparative Example 2, $1\times10^{14}$, in Example 6, $6\times10^{12}$) and volume specific resistance (in Comparative Example 2, $1.2\times10^{12}$, in Example 6, $2.4\times10^{9}$) were also small. Further, in Example 6, there was no substantial difference between the peel adhesive strength during the high speed peeling at a peeling speed of 30,000 mm/min and the peel adhesive strength during the low speed peeling at a peeling speed of 300 mm/min. This indicates that the peeling speed dependency of the peel adhesive strength is small, and the adhesive is excellent in the high speed peeling property. On the other hand, the acrylic pressure sensitive adhesive in Comparative Example 2 had a large peeling speed dependency of the peel adhesive strength, and the peel strength increased as the peeling speed became high.

[CONTAMINATION BY SILICONE]

With respect to the pressure sensitive adhesive sheet obtained in Example 6, samples having the following two types of separators bonded were prepared. (1) On the adhesive surface, a biaxially oriented polypropylene film having no treatment applied (hereinafter referred to as an OPP film) was press-bonded by using a rubber roller of 2 kg. (2) On the adhesive surface, a PET release film treated with silicone agent was press-bonded by using a rubber roller of 2 kg. Contamination of the adhesive surface by Si derived from the silicone treating agent was analyzed by FT-IR ATR method by the following method.

[METHOD FOR ANALYZING SILICONE ON THE SURFACE]

On the surface of a germanium prism washed with pure water and dried, the pressure sensitive adhesive sheet after peeling the separator was bonded. After press bonding it by hand, the pressure sensitive adhesive sheet was peeled. The surface of the germanium prism after peeling the pressure sensitive adhesive sheet, was measured. Further, separately, a PET release film treated with silicone was frictioned against a germanium prism to form a comparative sample.

[RESULTS OF ANALYZING SILICONE]

From the spectrum results in the case of using the silicone treated release paper, a peak derived from Si-$CH_3$ was observed in the vicinity of 1,270 $cm^{-1}$. Further, also with the sample of (2) wherein a PET release paper treated with silicone agent was used, the same peak was observed. On the other hand, with the sample of (1) (using non-treated OPP film), such a peak was not observed. With each sample, peeling of the separator from the adherence substance was very easy, and no adhesive deposit was observed. This indicates that for the pressure sensitive adhesive sheet of the present invention, a polyolefin such as a non-treated OPP film may be used as a separator.

[WATER CURABILITY]

To a silyl group-containing polymer (S2-1), a curing-agent (water) and a curing catalyst (DBTDL) were added to obtain a curable composition. The relation between the amount of the curing agent and the usable time was determined. 90 Parts by mass of a silyl group-containing polymer (S2-1), 10 parts by mass of toluene as a solvent and a predetermined amount of water were added and thoroughly stirred for 1 minute. Using an E type viscometer (No. 1 rotor), the viscosity was measured every 15 minutes. The temperature was maintained at 25˚C. The usable time was regarded as the time until the viscosity became 10,000 mPa·s/25˚C.

TABLE 5

| Curability Examples | Example 1 | Example 2 | Example 3 | Example 4 | Example 5 |
|---|---|---|---|---|---|
| Water (parts by mass) | 0.01 | 0.03 | 0.1 | 0.3 | 1 |
| Usable time (hr) | 3.25 | 2.75 | 1.75 | 1.25 | 0.75 |

The results are shown in Table 5. When from 0.01 to 1 part by mass of water was added to 90 parts by mass of the curable composition, an adequate usable time was obtainable.

[DILUTION WITH SOLVENT]

To a silyl group-containing polymer (S2-1), a curing agent (water) and a curing catalyst (DBTDL) were added to obtain a curable composition. The influence of an alcohol at the time of dilution with a solvent, over the usable time, was measured. To 100 parts by mass of the silyl group-containing polymer, 0.03 part by mass of water and 1 part by mass of the curing catalyst, 100 parts by mass in total of solvents were added. As the solvents, ethyl acetate and methanol were used. The mixing ratio was changed, and stirring was adequately carried out for 1 minute, and upon expiration of predetermined time, the viscosity was measured. Using an E type viscometer (No. 1 rotor), the viscosity at 25˚C was measured. The results are shown in Table 6. In the Table, "gel" shows that gelation took place.

TABLE 6

| Solvent dilution Examples | | Example 1 | Example 2 | Example 3 | Example 4 | Example 5 |
|---|---|---|---|---|---|---|
| Ethyl acetate (parts by mass) | | 100 | 70 | 50 | 30 | 0 |
| Methanol (parts by mass) | | 0 | 30 | 50 | 70 | 100 |
| Viscosity (mPa· s/ 25˚C) | Immediate after preparation | 60 | 57 | 51 | 50 | 46 |
| | 8.5 hr | 205 | 133 | 84 | 61 | 62 |
| | 24 hr | gel | 803 | 300 | 140 | 145 |
| | 48 hr | gel | gel | gel | 540 | 560 |

In the Table, other than the gelled ones, the coated state on a PET film was good. Further, after the coating, the composition was dried in an oven at 110˚C for 2 minutes and aged at 23˚C for 5 days. The peel adhesive strength of the obtained adherence substance was measured. Using a SUS plate treated by bright annealing, the peel adhesive strength upon expiration of 30 minutes after bonding was measured. With respect to the coated ones, the peel adhesion strength was substantially constant at a level of from 0.07 to 0.09 N/25 mm in each case.

By changing the ratio of methanol and ethyl acetate, the viscosity upon expiration of 48 hours can be maintained

to be low at a level of 600 mPa·s when the methanol is at least 70 mass%. That is, it was found that by adding an alcohol, it is possible to suppress the curing speed of the curable composition. This indicates that it is possible to control the stability (pot life) of the coating fluid, and at the same time, there is no influence over the properties of the obtained adherence substance.

[AGING PERIOD]

To 100 parts by mass of a silyl group-containing polymer (S2-1), 0.03 part by mass of water as a curing agent, 1.0 part by mass of DBTDL as a curing catalyst and 10 parts by mass of toluene as a diluting solvent, were added and stirred. The mixture was applied on a non-treated OPP film so that the thickness became about 17 μm. It was dried in an oven at 110°C for 2 minutes. On the coated surface of the OPP film taken out, a PET film having a thickness of 25 μm was bonded as a substrate. The laminate was aged at 23°C for a predetermined period, and then by using a SUS plate treated by bright annealing, the peel adhesive strength upon expiration of 30 minutes after bonding was measured.

Further, on the adherence substance coated surface of the OPP film, a similar OPP film was bonded, followed by aging at 23°C for a predetermined period. The mass of the adherence substance layer between the films was measured. Thereafter, the laminate was immersed in toluene for 3 days. The insoluble content was dried and the mass was measured. The mass after immersion to the mass before immersion was calculated as a gel fraction. The results are shown in Table 7.

TABLE 7

| Aging period examples | Example 1 | Example 2 | Example 3 | Example 4 |
|---|---|---|---|---|
| Number of aging days | 1 day | 2 days | 5 days | 90 days |
| Peel adhesive strength (N/25 mm) | 0.11 | 0.07 | 0.07 | 0.07 |
| Gel fraction (%) | 80 | 89 | 89 | 90 |

As is evident from the results in Table 7, 2 days are sufficient for the aging period. That is, it was found that the pressure sensitive adhesive properties can be stabilized in a short period until the pressure sensitive adhesive properties can be obtained. Further, it was found that there will be no change in the pressure sensitive adhesive properties even when stored for a long period of time.

INDUSTRIAL APPLICABILITY

According to the present invention, it is possible to obtain an adherence substance which has a low viscosity and good coatability, can be made solvent free, has a low adhesive strength, while the adhesion to an adherend is good, and which is excellent in removability and has good wettability. Further, according to the present invention, it is possible to obtain an adherence substance which has a peel electrostatic charge suppressed and is excellent in a high speed peeling property and which is free from contamination with e.g. silicone, and thus, it is useful particularly for a pressure sensitive adhesive sheet for protection of optical components or for a back grinding tape.

The entire disclosures of Japanese Patent Application No. 2007-097307 filed on April 3, 2007 and Japanese Patent Application No. 2007-277803 filed on October 25, 2007 including specifications, claims and summaries are incorporated herein by reference in their entireties.

## Claims

1. An adherence substance which is obtainable by curing a curable composition comprising a silyl group-containing polymer (S) represented by the following formula (1) and which has a peel adhesive strength of at most 1 N/25mm:

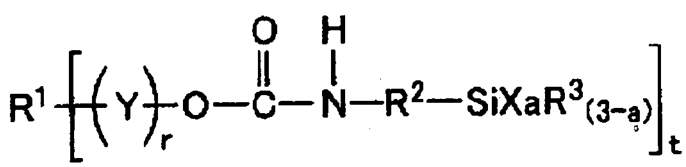

(1)

in the formula (1), $R^1$ represents a t-valent residue obtained by removing all hydroxy groups from a compound having t pieces of hydroxy groups in the molecule; $R^2$ represents a bivalent organic group; $R^3$ represents a monovalent organic group having from 1 to 20 carbon atoms; X is a hydroxy group or a hydrolyzable group; Y represents a bivalent group represented by the following formula (A) or a bivalent group represented by the following formula (B); a represents an integer of from 1 to 3; r represents an integer of from 1 to 1,000; t represents an integer of from 1 to 8; when t is from 2 to 8, t pieces of monovalent groups bonded to $R^1$ may be the same or different from one another; when a is 2 or 3, 2 or 3 pieces of X bonded to one silicon atom may be the same or different from one another; when a is 1, 2 pieces of $R^3$ bonded to one silicon atom may be the same or different from each other; and when r is 2 or more, the plurality of Y bonded to one another, may be the same or different from one another;

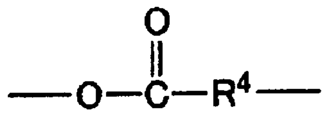

(A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

**2.** The adherence substance according to Claim 1, wherein the curable composition comprises, as the silyl group-containing polymer (S), a polyester ether type silyl group-containing polymer (S1) which is represented by the above formula (1) wherein r is an integer of from 2 to 1,000, and Y is a bivalent group represented by the formula (A) and a bivalent group represented by the formula (B).

**3.** The adherence substance according to Claim 2, wherein the polyester ether type silyl group-containing polymer (S1) is a polymer obtainable via a first step of reacting an initiator (z) made of a compound having from 1 to 8 hydroxy groups in the molecule, a cyclic ester compound (a) having from 3 to 9 carbon atoms and an alkylene oxide (b) having from 2 to 4 carbon atoms in the presence of a polymerization catalyst to obtain a polyester ether poly(mono)ol (p1), and a second step of reacting the polyester ether poly(mono)ol (p1) with a silyl isocyanate compound (i) in the presence of an urethane-forming catalyst to obtain the polyester ether type silyl group-containing polymer (S1).

**4.** The adherence substance according to Claim 3, wherein in the polyester ether type silyl group-containing polymer (S1), the mass ratio of the bivalent group represented by the formula (A) derived from the cyclic ester compound (a) to the bivalent group represented by the formula (B) derived from the alkylene oxide (b) i.e. (A):B), is from 95:5 to 5:95.

**5.** The adherence substance according to Claim 3 or 4, wherein the initiator (z) is a polyoxyalkylene poly(mono)ol (z2) which has from 1 to 8 hydroxy groups in the molecule and which also has an oxyalkylene group, and the polyester ether type silyl group-containing polymer (S1) is a polymer represented by the following formula (2):

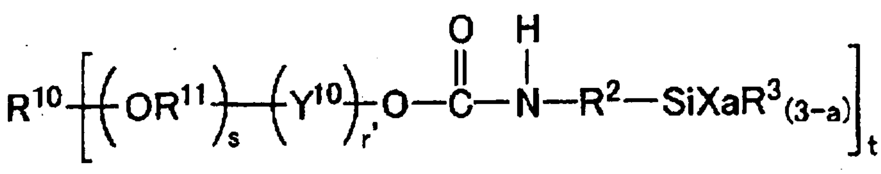

(2)

in the formula (2), $R^{10}$ represents a t-valent hydrocarbon group having from 1 to 20 carbon atoms; $R^{11}$ represents an alkylene group having from 2 to 4 carbon atoms derived from the polyoxyalkylene poly(mono)ol (z2); $R^2$ represents a bivalent organic group; $R^3$ represents a monovalent organic group having from 1 to 20 carbon atoms; X is a hydroxy group or a hydrolyzable group; $Y^{10}$ represents a bivalent group represented by the following formula (A) derived from the cyclic ester compound (a) or a bivalent group represented by the following formula (B) derived from the alkylene oxide (b); a represents an integer of from 1 to 3; r' represents an integer of at least 1; s represents an integer of from 1 to 250; the sum of r' and s is an integer of from 2 to 1,000; t represents an integer of from 1 to 8; when t is from 2 to 8, t pieces of monovalent groups bonded to $R^{10}$ may be the same or different from one another;

when a is 2 or 3, 2 or 3 pieces of X bonded to one silicon atom may be the same or different from one another; when a is 1, 2 pieces of $R^3$ bonded to one silicon atom may be the same or different from each other; when r' is 2 or more, the plurality of $Y^{10}$ bonded to one another, may be the same or different from one another; and when s is 2 or more, the plurality of $-OR^{11}-$ bonded to one another, may be the same or different from one another

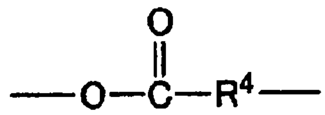

(A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

**6.** The adherence substance according to any one of Claims 3 to 5, wherein the polyester ether poly(mono)ol (p1) has an average hydroxy value (OHV) of from 10 to 230mgKOH/g.

**7.** The adherence substance according to any one of Claims 1 to 6, wherein the curable composition further contains another silyl group-containing polymer (S4) represented by the following formula (3):

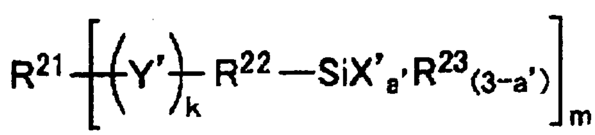

(3)

in the formula (3), $R^{21}$ represents a m-valent residue obtained by removing all hydroxy groups from a compound having m pieces of hydroxy groups in the molecule; $R^{22}$ represents a bivalent organic group; $R^{23}$ represents a monovalent organic group having from 1 to 20 carbon atoms; X' is a hydroxy group or a hydrolyzable group; Y' represents an oxyalkylene group having from 2 to 4 carbon atoms; a' represents an integer of from 1 to 3; k represents an integer of from 1 to 10,000; m represents an integer of from 1 to 8; when m is from 2 to 8, m pieces of monovalent groups bonded to $R^{21}$ may be the same or different from one another; when a' is 2 or 3, 2 or 3 pieces of X' bonded to one silicon atom may be the same or different from one another; when a' is 1, 2 pieces of $R^{23}$ bonded to one silicon atom may be the same or different from each other; and when k is 2 or more, the plurality of Y' bonded to one another, may be the same or different from one another.

**8.** An adherence substance which is obtainable by curing a curable composition comprising a silyl group-containing polymer (S) represented by the following formula (1):

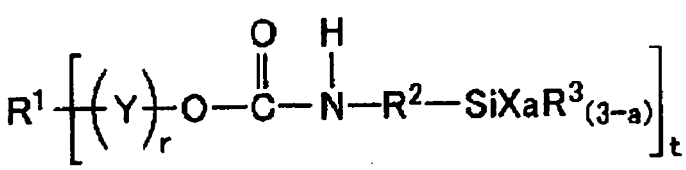

(1)

in the formula (1), $R^1$ represents a t-valent residue obtained by removing all hydroxy groups from a compound having t pieces of hydroxy groups in the molecule; $R^2$ represents a bivalent organic group; $R^3$ represents a monovalent organic group having from 1 to 20 carbon atoms; X is a hydroxy group or a hydrolyzable group; Y represents a combination of a bivalent group represented by the following formula (A) and a bivalent group represented by the following formula (B), or a combination of only a bivalent group represented by the following formula (A); a represents an integer of from 1 to 3; r represents an integer of from 2 to 1,000; t represents an integer of from 1 to 8; when t is from 2 to 8, t pieces of monovalent groups bonded to $R^1$ may be the same or different from one another; when a is 2 or 3, 2 or 3 pieces of X bonded to one silicon atom may be the same or different from one another; when a is 1, 2 pieces of $R^3$ bonded to one silicon atom may be the same or different from each other; and the plurality of

Y bonded to one another, may be the same or different from one another;

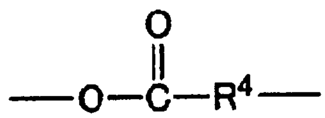 (A)

$-OR^5-$ (B)

in the formula (A), $R^4$ represents an alkylene group having from 2 to 8 carbon atoms; and in the formula (B), $R^5$ represents an alkylene group having from 2 to 4 carbon atoms.

**9.** A pressure sensitive adhesive sheet comprising a substrate layer and at least one layer of an adherence substance, wherein the adherence substance is one as defined in any one of Claims 1 to 8.

**10.** An optical element protective pressure sensitive adhesive sheet comprising a substrate layer and at least one layer of an adherence substance, wherein the adherence substance is one as defined in any one of Claims 1 to 8.

**11.** An optical element having the optical element protective pressure sensitive adhesive sheet as defined in Claim 10 bonded thereon.

**12.** The optical element according to Claim 11, wherein the optical element is a light diffusing plate or a prism sheet.

**13.** A back grinding tape comprising a substrate layer and at least one layer of an adherence substance, wherein the adherence substance is one as defined in any one of Claims 1 to 8.

**INTERNATIONAL SEARCH REPORT**

International application No.
PCT/JP2008/056602

A. CLASSIFICATION OF SUBJECT MATTER
*C09J183/12*(2006.01)i, *C09J7/02*(2006.01)i, *C09J201/10*(2006.01)i, *G02B1/10*
(2006.01)i

According to International Patent Classification (IPC) or to both national classification and IPC

B. FIELDS SEARCHED

Minimum documentation searched (classification system followed by classification symbols)
C09J183/12, C09J7/02, C09J201/10, G02B1/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2005/073334 A1 (Kaneka Corp.), 11 August, 2005 (11.08.05), Example 3; Par. Nos. [0008], [0047] & US 2007/0123662 A1 & EP 1715016 A1 | 1-13 |
| X | WO 2005/073333 A1 (Kaneka Corp.), 11 August, 2005 (11.08.05), Example 3; Par. No. [0042] & US 2007/0167584 A1 & EP 1715015 A1 | 1-13 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 June, 2008 (25.06.08) | 08 July, 2008 (08.07.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003012751 A
- WO 200573333 A
- WO 200573334 A
- JP 6297645 A
- JP 11106500 A
- JP 10036499 A
- JP 11302371 A
- JP 2007097307 A
- JP 2007277803 A